# EUROPEAN PATENT APPLICATION

(11) **EP 4 657 473 A1**
(43) Date of publication of application: **03.12.2025**
(21) Application number: 24848324.0
(22) Date of filing: 31.07.2024
(51) Int. Cl.: H01F 27/28, H05K 3/12, H02J 50/40

(54) **CHARGING COIL MODULE AND RELATED PRODUCT THEREOF, AND PREPARATION METHOD FOR CHARGING COIL MODULE**

(30) Priority: 02.08.2023 CN 202310970642
(71) Applicant: Huawei Technologies Co., Ltd., Shenzhen, Guangdong 518129 (CN)
(72) Inventor: GUO, Xuan, Shenzhen, Guangdong 518129 (CN); WANG, Jiabao, Shenzhen, Guangdong 518129 (CN); ZUO, Wei, Shenzhen, Guangdong 518129 (CN); BAO, Bin, Shenzhen, Guangdong 518129 (CN); XU, Qilin, Shenzhen, Guangdong 518129 (CN); ZHANG, Yuyao, Shenzhen, Guangdong 518129 (CN)
(74) Representative: MERH-IP Matias Erny Reichl Hoffmann Patentanwälte PartG mbB
(86) International application number: PCT/CN2024/108973
(87) International publication number: WO 2025/026369

(57) **Abstract**

This application provides a charging coil module and a related product thereof, and a preparation method for a charging coil module. In this application, a substrate of a circuit board and a substrate of a charging coil are disposed at a same layer, a first wiring layer and a first coil are disposed at a same layer, and a second wiring layer and a second coil are disposed at a same layer, so that the charging coil and the circuit board form an integrated structure. The first coil and the second coil may be directly electrically connected to a wire on the circuit board, for example, a wire at the first wiring layer of the circuit board or a wire at the second wiring layer of the circuit board. This can shorten a charging path between the charging coil and a load, to reduce a link loss. In addition, a BTB connector can be omitted, to simplify a structure of a charging coil module, and reduce costs of the charging coil module.

## Description

This application claims priority to Chinese Patent Application No. 202310970642.3, filed with the China National Intellectual Property Administration on August 2, 2023 and entitled "CHARGING COIL MODULE AND RELATED PRODUCT THEREOF, AND PREPARATION METHOD FOR CHARGING COIL MODULE", which is incorporated herein by reference in its entirety.

### TECHNICAL FIELD

This application relates to the wireless charging field, and in particular, to a charging coil module and a related product thereof, and a preparation method for a charging coil module.

### BACKGROUND

Currently, wireless charging technologies are attracting increasing attention from major manufacturers. In a power supply path of conventional wireless charging, a charging coil is electrically connected to a conversion sub-board through a coil BTB (board to board, board to board), and is then electrically connected to a charging FPC (flexible circuit board, flexible printed circuit) through the conversion sub-board and a sub-board BTB, and finally supplies, through the charging circuit board, power to a component or a chip that needs to be driven by electric energy. A conventional wireless charging coil has a long power supply path, a large loss, and low wireless charging efficiency.

### SUMMARY

Embodiments of this application provide a charging coil module, a related product including the charging coil module, and a preparation method including the charging coil module, to obtain a charging coil module with a short power supply path and a related product including the charging coil module.

According to a first aspect, a charging coil module is provided. The charging coil module includes a charging coil and a circuit board.

The charging coil includes a substrate, a first coil, and a second coil, and the substrate of the charging coil is located between the first coil and the second coil.

The circuit board includes a substrate, a first wiring layer, and a second wiring layer, and the substrate of the circuit board is located between the first wiring layer and the second wiring layer.

The substrate of the circuit board and the substrate of the charging coil are of an integrated structure, the first wiring layer and the first coil are disposed at a same layer, and the second wiring layer and the second coil are disposed at a same layer. It can be understood that the integrated structure may be two parts of a same board. Compared with a case in which the first coil and the second coil are electrically connected to the circuit board through a BTB connector, in this implementation, the first coil and the second coil may be directly electrically connected to a wire on the circuit board (for example, a wire at the first wiring layer of the circuit board or a wire at the second wiring layer of the circuit board). In this way, a charging path between the charging coil and a load can be shortened, to reduce a link loss and improve wireless charging efficiency.

It can be understood that the substrate of the circuit board and the substrate of the charging coil are disposed to be of an integrated structure, the first wiring layer and the first coil are disposed at a same layer, and the second wiring layer and the second coil are disposed at a same layer, so that the charging coil and the circuit board form an integrated structure, and the charging coil module has good structural strength. In this way, compared with a solution in which the charging coil is stacked on the circuit board, in this implementation, there is an overlapping region between the charging coil and the circuit board along a thickness direction, so that a thickness of the charging coil module can be greatly reduced.

It can be understood that, compared with a solution in which the charging coil and the circuit board are separately prepared and then the charging coil is connected to the circuit board through a BTB connector, in this implementation, the circuit board may be prepared during preparation of the charging coil, or the charging coil may be prepared during preparation of the circuit board. This can omit one process of preparing the charging coil or the circuit board, to reduce costs of the charging coil module. In addition, the charging coil and the circuit board are disposed to be of an integrated structure, so that a step of assembling the charging coil module can be omitted, to reduce difficulty in preparing the charging coil module.

In a possible implementation, the first wiring layer includes a first wire, and the first wire and the first coil are of an integrally formed structure; and/or
the second wiring layer includes a second wire, and the second wire and the second coil are of an integrally formed structure.

It can be understood that the first coil may be directly electrically connected to the first wire of the circuit board, and/or the second coil may be directly electrically connected to the second wire of the circuit board, to greatly shorten a charging path between the charging coil and a load, and reduce a link loss.

In a possible implementation, the charging coil includes a first insulation layer, the first insulation layer of the charging coil is disposed on the first coil and covers the first coil, and the first insulation layer of the charging coil and the first coil are located on a same side of the substrate of the charging coil.

The circuit board includes a first insulation layer, and the first insulation layer of the circuit board is disposed on the first wiring layer and covers the first wiring layer.

The first insulation layer of the charging coil and the first insulation layer of the circuit board are disposed at a same layer, and are of an integrally formed structure.

It can be understood that the first insulation layer of the charging coil and the first insulation layer of the circuit board are disposed at a same layer, so that the first insulation layer of the circuit board can be prepared during preparation of the first insulation layer of the charging coil, or the first insulation layer of the charging coil can be prepared during preparation of the first insulation layer of the circuit board. This can omit one process of preparing the first insulation layer of the charging coil or the first insulation layer of the circuit board, to reduce costs of the charging coil module.

In a possible implementation, along a length direction of the circuit board, the circuit board includes a first part, a second part, and a third part that are sequentially connected; and when the first part and the third part are folded or unfolded relative to each other, the second part is bent.

The circuit board includes a first insulation sublayer, a second insulation sublayer, and a third insulation sublayer. The first insulation sublayer is disposed on a first wiring layer of the second part. The second insulation sublayer is disposed on a first wiring layer of the first part. The third insulation sublayer is disposed on a first wiring layer of the third part.

Glass transition temperature of the first insulation sublayer is greater than glass transition temperature of the second insulation sublayer and glass transition temperature of the third insulation sublayer.

It can be understood that the glass transition temperature of the first insulation sublayer is set to be greater than the glass transition temperature of the second insulation sublayer and the glass transition temperature of the third insulation sublayer. In this way, the first insulation sublayer is not likely to undergo glass transition due to high-temperature processing in a subsequent process of the circuit board, to avoid an offset of a bending stress center line of the second part of the circuit board, and avoid a failure of the first insulation sublayer to protect the first wiring layer of the second part. In addition, the first insulation sublayer is not likely to undergo glass transition during folding or unfolding of the circuit board, to avoid an offset of the bending stress center line of the second part of the circuit board, and avoid a failure of the first insulation sublayer to protect the first wiring layer of the second part.

In a possible implementation, the charging coil includes a first insulation layer, and the first insulation layer of the charging coil is disposed on the first coil and covers the first coil.

The first insulation layer of the charging coil and the second insulation sublayer are of an integrally formed structure, or the first insulation layer of the charging coil and the third insulation sublayer are of an integrally formed structure.

It can be understood that the first insulation layer of the charging coil and the second insulation sublayer are disposed to be of an integrally formed structure, or the first insulation layer of the charging coil and the third insulation sublayer are of an integrally formed structure, so that the second insulation sublayer or the third insulation sublayer of the circuit board can be prepared during preparation of the first insulation layer of the charging coil, or the first insulation layer of the charging coil can be prepared during preparation of the second insulation sublayer or the third insulation sublayer of the circuit board. This can omit one process of preparing the first insulation layer of the charging coil or the second insulation sublayer or the third insulation sublayer of the circuit board, to reduce costs of the charging coil module.

In a possible implementation, the glass transition temperature of the first insulation sublayer is greater than or equal to 90°C, and both the glass transition temperature of the second insulation sublayer and the glass transition temperature of the third insulation sublayer are less than 90°C.

It can be understood that the glass transition temperature of the first insulation sublayer is set to be greater than or equal to 90°C. In this way, the first insulation sublayer is not likely to undergo glass transition due to high-temperature processing in a subsequent process of the circuit board, to avoid an offset of the bending stress center line of the second part of the circuit board, and avoid a failure of the first insulation sublayer to protect the first wiring layer of the second part. In addition, the first insulation sublayer is not likely to undergo glass transition during folding or unfolding of the circuit board, to avoid an offset of the bending stress center line of the second part of the circuit board, and avoid a failure of the first insulation sublayer to protect the first wiring layer of the second part.

In addition, because the first part and the third part of the circuit board may not be bent during folding or unfolding of the circuit board, a center line offset issue of the first part and the third part of the circuit board may not need to be considered. In this implementation, both the glass transition temperature of the second insulation sublayer and the glass transition temperature of the third insulation sublayer are set to be less than 90°C. In this way, the second insulation sublayer and the third insulation sublayer can be disposed on the first wiring layer of the first part and the first wiring layer of the third part respectively without high-temperature processing, to reduce difficulty in performing coverage by using the second insulation sublayer and the third insulation sublayer.

In a possible implementation, both a thickness of the first wiring layer of the first part and a thickness of the first wiring layer of the third part are greater than a thickness of the first wiring layer of the second part.

It can be understood that the thickness of the first wiring layer of the second part is set to be small, to adjust the stress center line of the second part of the circuit board, to make the stress center line of the second part of the circuit board fall on an insulation layer of the second part of the circuit board, to be specific, prevent the stress center line of the second part of the circuit board from falling on the first wiring layer of the second part. This ensures that the first insulation sublayer can protect the first wiring layer of the second part, to improve service life of the charging coil module.

In a possible implementation, the first wiring layer of the first part includes three metal layers, and a second wire of the second part includes two metal layers.

A first layer of metal of the first wiring layer of the first part and a first layer of metal of the first wiring layer of the second part are disposed at a same layer, and are of an integrally formed structure.

A second layer of metal of the first wiring layer of the first part and a second layer of metal of the first wiring layer of the second part are disposed at a same layer, and are of an integrally formed structure.

It can be understood that, because the first wiring layer of the second part does not include a third layer of metal, a third layer of metal of the first wiring layer of the first part protrudes from the second layer of metal of the first wiring layer of the second part.

In a possible implementation, a distance d₁ between the first insulation sublayer and the third layer of metal of the first wiring layer of the first part satisfies 0.2 millimeter ≤ d₁ ≤ 0.5 millimeter. This can ensure that the first wiring layer and a second wiring layer of the second part of the circuit board are not likely to break due to excessively concentrated stress, to ensure that the charging coil module has long service life.

In a possible implementation, a part of the second insulation sublayer overlaps the first insulation sublayer.

A width L₁ of a part, disposed on the first insulation sublayer, of the second insulation sublayer satisfies L₁ ≥ 0.05 millimeter. In this way, during bending of the second part of the circuit board, the first insulation sublayer and the second insulation sublayer are not likely to be separated at a joint, the first wiring layer of the second part of the circuit board can be covered by the first insulation sublayer and the second insulation sublayer, and the first wiring layer of the second part of the circuit board is not likely to break, to ensure that the charging coil module has long service life.

In a possible implementation, a thickness of a first adhesive layer of the first insulation sublayer is less than a thickness of a second adhesive layer of the second insulation sublayer and a thickness of a third adhesive layer of the third insulation sublayer.

It can be understood that the thickness of the first adhesive layer of the first insulation sublayer is set to be small, so that the thin first wiring layer of the second part is covered by the thin first adhesive layer of the first insulation sublayer, to ensure that the first wiring layer of the second part of the circuit board can be well covered without greatly increasing a thickness of the circuit board, to well protect the first wiring layer of the second part.

In addition, the thickness of the second adhesive layer of the second insulation sublayer is set to be large, so that the thick first wiring layer of the first part is covered by the thick second adhesive layer of the second insulation sublayer, to ensure that the second insulation sublayer can well cover the first wiring layer of the first part of the circuit board, to be specific, the second insulation sublayer can well fill a gap between two adjacent wires at the first wiring layer of the first part.

In addition, the thickness of the third adhesive layer of the third insulation sublayer is set to be large, so that the thick first wiring layer of the third part is covered by the thick third adhesive layer of the third insulation sublayer, to ensure that the third insulation sublayer can well cover the first wiring layer of the third part of the circuit board, to be specific, the third insulation sublayer can well fill a gap between two adjacent wires at the first wiring layer of the third part.

In a possible implementation, the thickness of the first adhesive layer of the first insulation sublayer is less than 25 micrometers, and the thickness of the second adhesive layer of the second insulation sublayer and the thickness of the third adhesive layer of the third insulation sublayer are greater than 25 micrometers.

In a possible implementation, the charging coil includes a first nanocrystalline layer and a first graphite layer, and the first nanocrystalline layer and the first graphite layer are sequentially stacked on the first insulation layer of the charging coil.

In a possible implementation, a quantity of turns of the first coil is greater than or equal to 2, and a distance between two adjacent turns of the first coil ranges from 40 micrometers to 100 micrometers.

It can be understood that the first coil in the charging coil can be arranged at a narrow spacing. When sizes are the same, compared with a charging coil in which narrow-spacing arrangement is not implemented, the charging coil in this implementation contains more metal (for example, copper) per unit area, so that a charging loss is effectively reduced. This helps extend duration in which the charging coil remains at a peak value of 50 W during charging, and improves charging efficiency.

In addition, when outer diameters of charging coils are the same, compared with a charging coil module in which narrow-spacing arrangement is not implemented, in the charging coil in this implementation, the first coil in the charging coil can be arranged at a narrow spacing without reducing a size of a wire in the first coil, to reduce a thickness of the first coil and reduce an overall thickness of the charging coil. In other words, in the charging coil in this implementation, the distance between two adjacent turns of the first coil may be reduced to miniaturize the charging coil.

In a possible implementation, each turn of the first coil includes a first conducting portion and a second conducting portion, the first conducting portion is disposed on the substrate of the charging coil, and the second conducting portion is formed on the first conducting portion through electroplating.

In a possible implementation, a wire width of the first coil is greater than or equal to 50 micrometers. For example, the wire width of the first coil ranges from 50 micrometers to 100 micrometers. This helps reduce charging impedance of the charging coil.

In a possible implementation, the thickness of the first coil is greater than or equal to 50 micrometers. For example, the thickness of the first coil ranges from 50 micrometers to 100 micrometers. This helps reduce charging impedance of the charging coil.

In a possible implementation, the first conducting portion further includes two layers of metal, a second layer of metal is formed on a first layer of metal through electroplating, and the first layer of metal is disposed on the substrate of the charging coil.

According to a second aspect, an electronic device is provided. The electronic device includes a battery and the foregoing charging coil module. The charging coil module is configured to charge the battery. The charging coil module with high charging efficiency is used in the electronic device, so that the electronic device can also achieve high charging efficiency.

According to a third aspect, a charger is provided. The charger includes the foregoing charging coil module. The charging coil module with high charging efficiency is used in the charger, so that the charger can also achieve high charging efficiency.

According to a fourth aspect, a charging system is provided. The charging system includes an electronic device and a charger. At least one of the electronic device and the charger includes the foregoing charging coil module. The charger is configured to charge the electronic device.

According to a fifth aspect, a preparation method for a charging coil module is provided. The method includes:
preparing a double-sided board, where the double-sided board includes a substrate, a first etching layer, and a second etching layer, and the substrate of the double-sided board is located between the first etching layer and the second etching layer;
processing the first etching layer of the double-sided board to form a first coil of a charging coil and a first wiring layer of a circuit board; and
processing the second etching layer of the double-sided board to form a second coil of the charging coil and a second wiring layer of the circuit board.

It can be understood that the substrate of the circuit board and the substrate of the charging coil are formed through a same process, the first wiring layer and the first coil are formed through a same process, and the second wiring layer and the second coil are formed through a same process, so that the charging coil and the circuit board form an integrated structure.

It can be understood that, compared with a solution in which the charging coil and the circuit board are separately prepared and then the charging coil is connected to the circuit board through a BTB connector, in this implementation, the circuit board may be prepared during preparation of the charging coil, or the charging coil may be prepared during preparation of the circuit board. This can omit one process of preparing the charging coil or the circuit board, to reduce costs of the charging coil module. In addition, the charging coil and the circuit board are disposed to be of an integrated structure, so that a step of assembling the charging coil module can be omitted, to reduce difficulty in preparing the charging coil module.

In addition, compared with a case in which the first coil and the second coil are electrically connected to the circuit board through a BTB connector, in this implementation, the first coil and the second coil may be directly electrically connected to a wire on the circuit board (for example, a wire at the first wiring layer of the circuit board or a wire at the second wiring layer of the circuit board), so that the BTB connector can be omitted, to simplify a structure of the charging coil module, and reduce costs of the charging coil module.

In a possible implementation, the first wiring layer includes a first wire, and the first wire and the first coil are of an integrally formed structure; and/or
the second wiring layer includes a second wire, and the second wire and the second coil are of an integrally formed structure.

It can be understood that the first coil may be directly electrically connected to the first wire of the circuit board, and/or the second coil may be directly electrically connected to the second wire of the circuit board, to greatly shorten a charging path between the charging coil and a load, and reduce a link loss.

In a possible implementation, in the step of preparing the double-sided board, the method includes:
bonding a first substrate of a first flexible copper clad laminate and a second substrate of a second flexible copper clad laminate to two surfaces of a bonding sheet;
press-fitting the first flexible copper clad laminate, the bonding sheet, and the second flexible copper clad laminate;
forming a third metal layer on a first metal layer of the first flexible copper clad laminate through electroplating, where the first metal layer and the third metal layer form the first etching layer; and
forming a fourth metal layer on a second metal layer of the second flexible copper clad laminate through electroplating, where the second metal layer and the fourth metal layer form the second etching layer.

In a possible implementation, the method further includes:
forming a first covering layer on the first coil of the charging coil and the first wiring layer of the circuit board, and forming a second covering layer on the second coil of the charging coil and the second wiring layer of the circuit board, where the first covering layer includes a first insulation layer of the charging coil and a first insulation layer of the circuit board, and the second covering layer includes a second insulation layer of the charging coil and a second insulation layer of the circuit board.

It can be understood that the first insulation layer of the charging coil and the first insulation layer of the circuit board are formed through a same process. To be specific, the first insulation layer of the circuit board can be prepared during preparation of the first insulation layer of the charging coil, or the first insulation layer of the charging coil can be prepared during preparation of the first insulation layer of the circuit board. This can omit one process of preparing the first insulation layer of the charging coil or the first insulation layer of the circuit board, to reduce costs of the charging coil module.

It can be understood that the second insulation layer of the charging coil and the second insulation layer of the circuit board are formed through a same process. To be specific, the second insulation layer of the circuit board can be prepared during preparation of the second insulation layer of the charging coil, or the second insulation layer of the charging coil can be prepared during preparation of the second insulation layer of the circuit board. This can omit one process of preparing the second insulation layer of the charging coil or the second insulation layer of the circuit board, to reduce costs of the charging coil module.

In a possible implementation, along a length direction of the circuit board, the circuit board includes a first part, a second part, and a third part that are sequentially connected; and when the first part and the third part are folded or unfolded relative to each other, the second part is bent.

The method further includes:
forming a first insulation sublayer on a first wiring layer of the second part of the circuit board;
forming a second insulation sublayer on a first wiring layer of the first part of the circuit board, where a part of the second insulation sublayer overlaps the first insulation sublayer, and glass transition temperature of the first insulation sublayer is greater than glass transition temperature of the second insulation sublayer;
forming a third insulation sublayer on a first wiring layer of the third part of the circuit board, where a part of the third insulation sublayer overlaps the first insulation sublayer, and the glass transition temperature of the first insulation sublayer is greater than glass transition temperature of the third insulation sublayer; and
press-fitting the first insulation sublayer, the second insulation sublayer, and the third insulation sublayer.

It can be understood that the glass transition temperature of the first insulation sublayer is set to be greater than the glass transition temperature of the second insulation sublayer and the glass transition temperature of the third insulation sublayer. In this way, the first insulation sublayer is not likely to undergo glass transition due to high-temperature processing in a subsequent process of the circuit board, to avoid an offset of a bending stress center line of the second part of the circuit board, and avoid a failure of the first insulation sublayer to protect the first wiring layer of the second part. In addition, the first insulation sublayer is not likely to undergo glass transition during folding or unfolding of the circuit board, to avoid an offset of the bending stress center line of the second part of the circuit board, and avoid a failure of the first insulation sublayer to protect the first wiring layer of the second part.

In a possible implementation, the press-fitting is a thermal compression bonding process, thermal compression bonding temperature of the thermal compression bonding process ranges from 150°C to 200°C, and thermal compression bonding time of the thermal compression bonding process ranges from 0.5 hour to 3 hours; or
the press-fitting is a pressure transfer process, pressure transfer temperature of the pressure transfer process ranges from 170°C to 190°C, and thermal compression bonding time of the pressure transfer process ranges from 0.5 hour to 3 hours; or
the press-fitting is a rapid pressure bonding process, rapid pressure bonding temperature of the rapid pressure bonding process ranges from 170°C to 190°C, and rapid pressure bonding time of the rapid pressure bonding process ranges from 1 minute to 8 minutes.

It can be understood that, in this implementation, through one press-fitting process, the first insulation sublayer can be prevented from undergoing glass transition at a plurality of times of high temperature, to avoid an offset of a stress center line of the second part of the circuit board, and avoid a failure to protect the first wiring layer of the second part during movement and folding.

### BRIEF DESCRIPTION OF DRAWINGS

To describe the technical solutions in embodiments of this application or in the background more clearly, the following briefly describes the accompanying drawings used in embodiments of this application or in the background.
FIG. 1 is a diagram of a structure of a wireless charging system according to an embodiment of this application;
FIG. 2 is a diagram of a structure of an electronic device in a wireless charging system shown in FIG. 1 according to an implementation;
FIG. 3 is a diagram of a structure of a charging coil module shown in FIG. 2 according to an implementation;
FIG. 4 is a diagram of a structure of a charging coil shown in FIG. 3 according to an implementation;
FIG. 5 is a partial exploded view of a charging coil shown in FIG. 4 according to an implementation;
FIG. 6 is a diagram of a structure of a substrate, a first coil, and a second coil shown in FIG. 4;
FIG. 7 is a diagram of a structure of a first coil shown in FIG. 6 according to an implementation;
FIG. 8 is a partial cross-sectional view of a structure shown in FIG. 6 at a line A-A according to an implementation;
FIG. 9 is a partial cross-sectional view of a charging coil module shown in FIG. 3 at a line B-B according to an implementation;
FIG. 10 is a diagram of a partial structure of a charging coil module shown in FIG. 3 according to an implementation;
FIG. 11 is a diagram of a structure of a partial charging coil module shown in FIG. 10 at another angle;
FIG. 12 is a flowchart of preparing a charging coil module shown in FIG. 3;
FIG. 13 to FIG. 23 are diagrams 1 to 11 of structures of some steps of a preparation method for a charging coil module shown in FIG. 12 according to some embodiments;
FIG. 24 is a partial cross-sectional view of a charging coil module shown in this implementation according to another implementation;
FIG. 25 is a diagram of a structure of an electronic device in an unfolded state in an implementation according to an embodiment of this application;
FIG. 26 is a partial exploded view of an electronic device shown in FIG. 25 according to an implementation;
FIG. 27 is a diagram of a structure of a charging coil module shown in FIG. 25 according to an implementation;
FIG. 28 is a partial cross-sectional view of a charging coil module shown in FIG. 27 at a line G-G according to an implementation;
FIG. 29 and FIG. 30 are diagrams 1 and 2 of structures of some steps of a preparation method for a charging coil module shown in FIG. 12 according to some other embodiments;
FIG. 31 is a flowchart of preparing a charging coil module shown in FIG. 28 according to an implementation; and
FIG. 32 is a diagram 1 of a structure of some steps of a preparation method for a charging coil module shown in FIG. 31 according to some embodiments.

### DESCRIPTION OF EMBODIMENTS

The following describes embodiments of this application with reference to the accompanying drawings in embodiments of this application.

In the descriptions of embodiments of this application, it should be noted that the term "connection" should be understood in a broad sense, unless otherwise specified or limited expressly. For example, the "connection" may be a detachable connection or a non-detachable connection, or may be a direct connection or an indirect connection through an intermediate medium. In addition, obtaining an integrated structure of two components through an integral forming process means that, in a process of forming one of the two components, the component is connected to the other component, and the two components do not need to be connected through reprocessing (for example, bonding, welding, clamping, or screwing).

In addition, orientation terms such as "left" and "right" mentioned in embodiments of this application merely indicate directions with reference to the accompanying drawings. Therefore, the orientation terms are intended for better and more clearly describing and understanding embodiments of this application, but not to indicate or imply that a specified apparatus or element needs to have a specific orientation or be constructed or operated in a specific orientation, and therefore cannot be construed as a limitation on embodiments of this application. "A plurality of" means at least two.

In embodiments of this application, the terms "first", "second", "third", and "fourth" are merely intended for description, and shall not be understood as an indication or implication of relative importance or an implicit indication of a quantity of indicated technical features. Therefore, a feature limited by "first", "second", "third", and "fourth" may explicitly or implicitly include one or more features.

In embodiments of this application, "and/or" describes only an association relationship between associated objects, and indicates that three relationships may exist. For example, A and/or B may indicate the following three cases: Only A exists, both A and B exist, and only B exists. In addition, the character "/" in this specification usually indicates an "or" relationship between the associated objects.

Reference to "an implementation", "some implementations", or the like described in this specification means that one or more embodiments of this application include a specific feature, structure, or characteristic described with reference to the embodiment. Therefore, statements such as "in some implementations" and "in other implementations" that appear at different places in this specification do not necessarily mean referring to a same embodiment. Instead, the statements mean "one or more but not all of embodiments", unless otherwise specifically emphasized in another manner. The terms "include", "have", and their variants all mean "including but not limited to", unless otherwise specifically emphasized in another manner.

It can be understood that specific embodiments described herein are merely intended to explain a related invention, but not to limit the invention. In addition, it should be further noted that, for ease of description, only a part related to the invention is shown in the accompanying drawings.

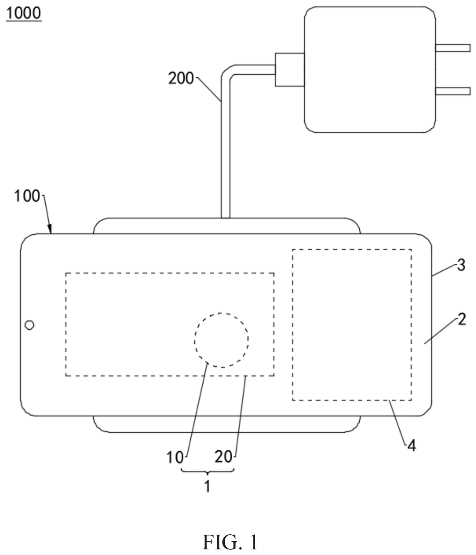

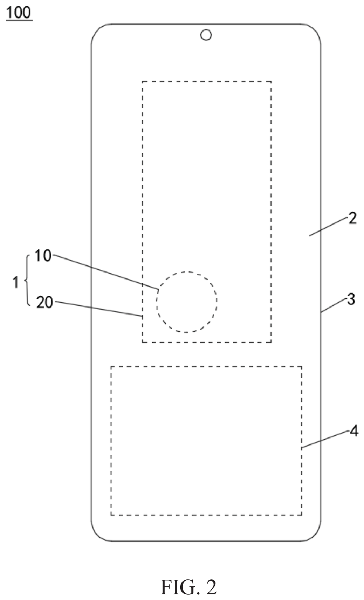

FIG. 1 is a diagram of a structure of a wireless charging system 1000 according to an embodiment of this application. FIG. 2 is a diagram of a structure of an electronic device 100 in the wireless charging system 1000 shown in FIG. 1 according to an implementation.

As shown in FIG. 1 and FIG. 2, the wireless charging system 1000 may include the electronic device 100 and a wireless charger 200. When the wireless charger 200 is connected to a power supply, the wireless charger 200 may be configured to wirelessly charge the electronic device 100. In FIG. 1 and FIG. 2, an example in which the electronic device 100 includes a charging coil module 1 is used for illustration. The electronic device 100 may be a mobile phone, a tablet computer, a foldable terminal device, a wearable device, or a device in another form that has a wireless charging function. The wearable device may be a smart band, a smart watch, smart glasses, or the like. In the embodiment shown in FIG. 1 and FIG. 2, an example in which the electronic device 100 is a mobile phone is used for description.

In this implementation, the electronic device 100 may be a bar-type device (to be specific, an electronic device that cannot be folded), or may be a foldable device (to be specific, an electronic device that can be folded). The following describes the electronic device 100 of the two structures in detail with reference to related accompanying drawings. First, an example in which the electronic device 100 is a bar-type device is used for description.

As shown in FIG. 1 and FIG. 2, the electronic device 100 is a bar-type device. The electronic device 100 may include a charging coil module 1, a display 2, a housing 3, and a load 4. The display 2 may be fastened to the housing 3. The display 2 and the housing 3 may enclose an internal space of the electronic device 100. Both the charging coil module 1 and the load 4 may be located in the internal space of the electronic device 100. The load 4 may be a battery, a chip, a speaker, a camera, or another to-be-charged component. In FIG. 1 and FIG. 2, an example in which the load 4 is a battery is used for illustration.

It can be understood that FIG. 1 and FIG. 2 merely show some components of the electronic device 100 as an example. Actual shapes and actual sizes of the components are not limited by FIG. 1 or the following accompanying drawings. In addition, because both the charging coil module 1 and the load 4 are internal components of the electronic device 100, FIG. 1 and FIG. 2 show the charging coil module 1 and the load 4 by using dashed lines. In another implementation, when the electronic device 100 is in another form, the electronic device 100 may alternatively not include the display 2.

As shown in FIG. 1 and FIG. 2, the charging coil module 1 may be electrically connected to the load 4. When the electronic device 100 is in a charging state, the charging coil module 1 may charge the load 4.

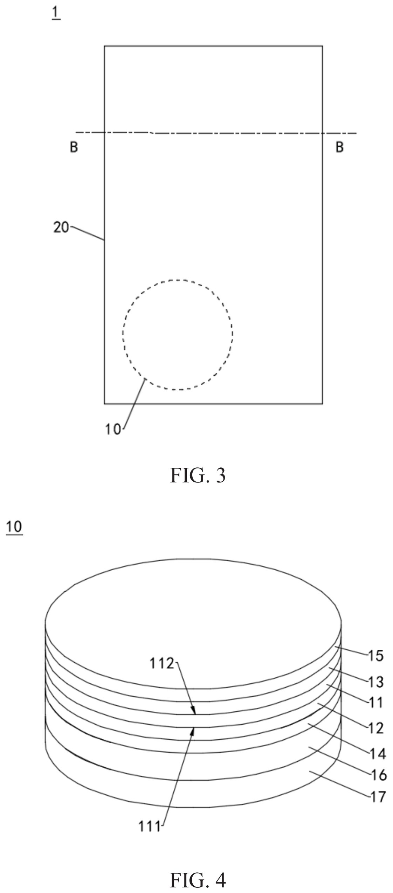

FIG. 3 is a diagram of a structure of the charging coil module 1 shown in FIG. 2 according to an implementation.

As shown in FIG. 3, the charging coil module 1 may include a charging coil 10 and a circuit board 20. The charging coil 10 and the circuit board 20 are of an integrated structure. It can be understood that, in this implementation, the circuit board 20 is formed during forming of a structure of the charging coil 10. In this way, compared with a solution in which the charging coil 10 and the circuit board 20 are separately formed and then the charging coil 10 is electrically connected to the circuit board 20 through a BTB, in the solution in this implementation, a quantity of steps of preparing the charging coil module 1 can be reduced, to reduce costs. In addition, in this implementation, the BTB can be omitted. This can not only further reduce component costs, but also shorten an electrical connection path between the charging coil 10 and the circuit board 20, to reduce a loss.

It can be understood that the charging coil module 1 may alternatively include more structures. For example, the charging coil module 1 may further include a system-on-a-chip (system-on-a-chip, SoC) (not shown in the figure). The SoC may be integrated on the circuit board 20.

It should be noted that the circuit board may be a main board in the electronic device or a flexible board in the electronic device.

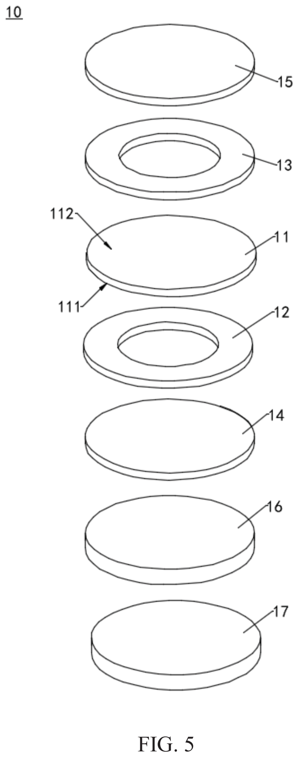

FIG. 4 is a diagram of a structure of the charging coil 10 shown in FIG. 3 according to an implementation. FIG. 5 is a partial exploded view of the charging coil 10 shown in FIG. 4 according to an implementation.

As shown in FIG. 4 and FIG. 5, for example, the charging coil 10 includes a substrate 11, a first coil 12, a second coil 13, a first insulation layer 14, a second insulation layer 15, a first nanocrystalline layer 16, and a first graphite layer 17.

In an implementation, a material of the substrate 11 of the charging coil 10 may be an insulation material. For example, the substrate 11 of the charging coil 10 includes a three-layer structure, and specifically includes a first PI layer, a bonding layer, and a second PI layer that are sequentially stacked. The bonding layer is made of a polymer insulation bonding sheet (bonding sheet).

In an implementation, both a material of the first coil 12 and a material of the second coil 13 may be metal. For example, both the material of the first coil 12 and the material of the second coil 13 may be copper.

In an implementation, the first insulation layer 14 and the second insulation layer 15 of the charging coil 10 may be made of an insulation material. For example, both the first insulation layer 14 and the second insulation layer 15 of the charging coil 10 are of a two-layer structure, and specifically include a PI layer and an adhesive layer.

As shown in FIG. 4 and FIG. 5, the substrate 11 of the charging coil 10 may include a first surface 111 and a second surface 112 that are arranged facing away from each other. The first coil 12 may be disposed on the first surface 111 of the substrate 11 of the charging coil 10. The second coil 13 may be disposed on the second surface 112 of the substrate 11 of the charging coil 10. In other words, the substrate 11 of the charging coil 10 is disposed between the first coil 12 and the second coil 13.

In addition, the first insulation layer 14 of the charging coil 10 may be disposed on the first coil 12 and cover the first coil 12. The first nanocrystalline layer 16 may be disposed on a side, away from the first coil 12, of the first insulation layer 14. The first graphite layer 17 may be connected to a surface, away from the first insulation layer 14, of the first nanocrystalline layer 16. In addition, the second insulation layer 15 may be disposed on the second coil 13 and cover the second coil 13. The first insulation layer 14 of the charging coil 10 and the first coil 12 are located on a same side of the substrate 11 of the charging coil 10. The second insulation layer 15 of the charging coil 10 and the second coil 13 are located on a same side of the substrate 11 of the charging coil 10.

It can be understood that the first insulation layer 14 of the charging coil 10 may be configured to protect the first coil 12. The second insulation layer 15 of the charging coil 10 may be configured to protect the second coil 13.

It can be understood that the charging coil 10 may alternatively include more or fewer structures. For example, the charging coil 10 may include more structures. The charging coil 10 may further include a second nanocrystalline layer and a second graphite layer. The second nanocrystalline layer and the second graphite layer are sequentially stacked on the second insulation layer 15. For another example, the charging coil 10 may include fewer structures. The charging coil 10 may alternatively not include the first nanocrystalline layer 16, the first graphite layer 17, and/or the like.

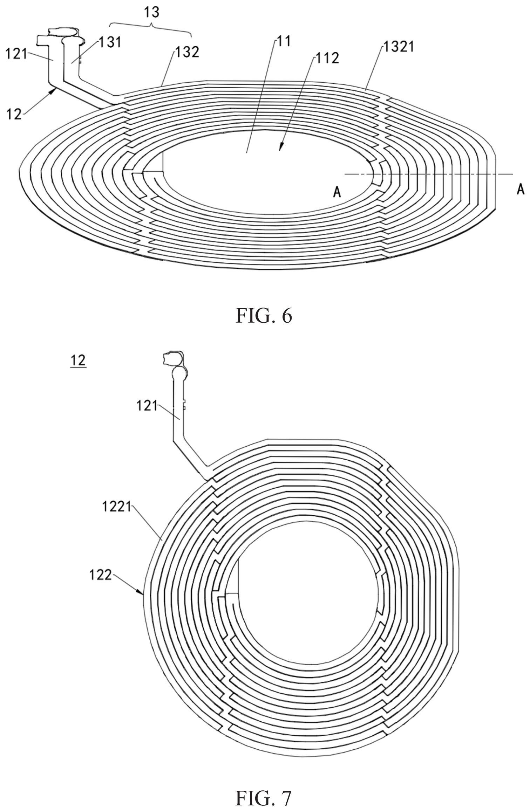

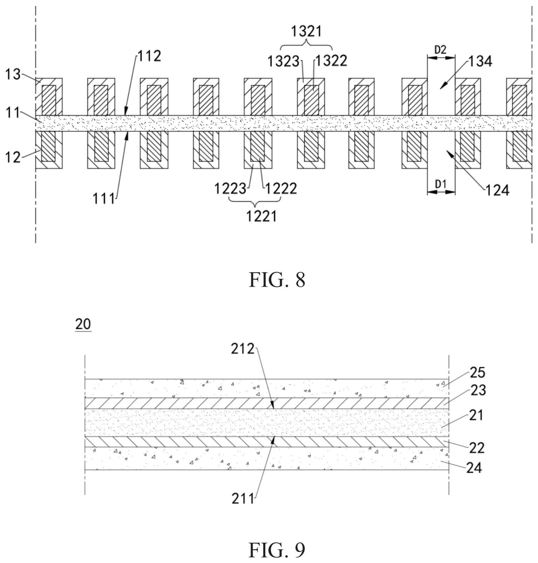

FIG. 6 is a diagram of a structure of the substrate 11, the first coil 12, and the second coil 13 shown in FIG. 4. FIG. 7 is a diagram of a structure of the first coil 12 shown in FIG. 6 according to an implementation. FIG. 8 is a partial cross-sectional view of the structure shown in FIG. 6 at a line A-A according to an implementation.

As shown in FIG. 6 to FIG. 8, the first coil 12 may include a first leading wire portion 121 and a first body portion 122. The first leading wire portion 121 is connected to an output end of the first body portion 122. It can be understood that, in FIG. 6, because the first coil 12 is located at the bottom of the second coil 13 and the second coil 13 blocks a part of the first coil 12, the first coil 12 is not shown in FIG. 6.

For example, the first body portion 122 includes a plurality of first sub-coils 1221 that are disposed at spacings and that are electrically connected to each other. It can be understood that one first sub-coil 1221 may form one turn of the first coil 12. A quantity of turns of the first coil 12 is greater than or equal to 2.

For example, one end of the first leading wire portion 121 may be electrically connected to an outermost one of the plurality of first sub-coils 1221.

For example, a spacing D1 between two adjacent first sub-coils 1221, namely, a distance between two adjacent turns of the first coil 12, may range from 40 micrometers to 100 micrometers. For example, the spacing between two adjacent first sub-coils 1221 may be 40 micrometers, 50 micrometers, 60 micrometers, 80 micrometers, or 100 micrometers. In this case, a wire spacing of the first coil 12 is narrow, and the first coil 12 can be arranged at a narrow spacing. It can be understood that a first gap 124 may be formed between two adjacent first sub-coils 1221. The spacing between two adjacent first sub-coils 1221 may be a minimum width of the first gap 124.

The following specifically describes a structure of the first sub-coil 1221 in an implementation with reference to related accompanying drawings.

As shown in FIG. 6 to FIG. 8, the first sub-coil 1221 may include a first conducting portion 1222 and a second conducting portion 1223. The first conducting portion 1222 is disposed on the first surface 111 of the substrate 11. The second conducting portion 1223 is wrapped around an outer surface of the first conducting portion 1222. For example, the second conducting portion 1223 may be formed on the first conducting portion 1222 through an electroplating process.

In some implementations, the second conducting portion 1223 is formed on the first conducting portion 1222 of the first coil 12 through leading wire electroplating.

It can be understood that the spacing D1 between two adjacent first sub-coils 1221 is a spacing between second conducting portions 1223 of the two adjacent first sub-coils 1221. Space between the second conducting portions 1223 of the two adjacent first sub-coils 1221 is the first gap 124.

In some implementations, the first conducting portion 1222 of the first sub-coil 1221 further includes two layers of metal. A second layer of metal is formed on a first layer of metal through electroplating, and the first layer of metal is disposed on the substrate 11 of the charging coil 10.

As shown in FIG. 6 and FIG. 8, the second coil 13 may include a second leading wire portion 131 and a second body portion 132. The second leading wire portion 131 is connected to an output end of the second body portion 132.

For example, the second body portion 132 includes a plurality of second sub-coils 1321 that are disposed at spacings and that are electrically connected to each other. It can be understood that one second sub-coil 1321 may form one turn of the second coil 13. A quantity of turns of the second coil 13 is greater than or equal to 2.

For example, one end of the second leading wire portion 131 may be electrically connected to an outermost one of the plurality of second sub-coils 1321.

For example, a spacing D2 between two adjacent second sub-coils 1321, namely, a distance between two adjacent turns of the second coil 13, may range from 40 micrometers to 100 micrometers. For example, the spacing between two adjacent second sub-coils 1321 may be 40 micrometers, 50 micrometers, 60 micrometers, 80 micrometers, or 100 micrometers. In this case, a wire spacing of the second coil 13 is narrow, and the second coil 13 can be arranged at a narrow spacing. It can be understood that a second gap 134 may be formed between two adjacent second sub-coils 1321. The spacing between two adjacent second sub-coils 1321 may be a minimum width of the second gap 134.

The following specifically describes a structure of the second sub-coil 1321 in an implementation with reference to related accompanying drawings.

As shown in FIG. 6 to FIG. 8, the second sub-coil 1321 may include a first conducting portion 1322 and a second conducting portion 1323. The first conducting portion 1322 is disposed on the second surface 112 of the substrate 11. The second conducting portion 1323 is wrapped around an outer surface of the first conducting portion 1322. For example, the second conducting portion 1323 may be formed on the first conducting portion 1322 through an electroplating process.

In some implementations, the second conducting portion 1323 is formed on the first conducting portion 1322 of the second coil 13 through leading wire electroplating.

It can be understood that the spacing D2 between two adjacent second sub-coils 1321 is a spacing between second conducting portions 1323 of the two adjacent second sub-coils 1321. Space between the second conducting portions 1323 of the two adjacent second sub-coils 1321 is the second gap 134.

In some implementations, the first conducting portion 1322 of the second sub-coil 1321 further includes two layers of metal. A second layer of metal is formed on a first layer of metal through electroplating, and the first layer of metal is disposed on the substrate 11 of the charging coil 10.

It can be understood that the second coil 13 and the first coil 12 may be of a same structure, similar structures, symmetric or partially symmetric structures, or different structures. In this implementation, the second coil 13 and the first coil 12 are of symmetric structures. For a basic design of a component structure of the second coil 13, a design of a connection relationship between components, and a design of a connection relationship between a component and another structure other than a component, refer to a related solution of the first coil 12. In addition, the second coil 13 and the first coil 12 are allowed to be slightly different in terms of a detailed structure or position arrangement of components. An example is described below.

For example, the charging coil 10 may further include a plurality of vias (not shown in the figure). All of the plurality of vias may pass through the first surface 111 and the second surface 112 of the substrate 11 of the charging coil 10. The plurality of first sub-coils 1221 of the first coil 12 may be electrically connected to the plurality of second sub-coils 1321 of the second coil 13 in a one-to-one correspondence through the plurality of vias 14, to implement an electrical connection between internal wires of the entire charging coil 10.

It can be understood that both the first coil 12 and the second coil 13 in the charging coil 10 can be arranged at a narrow spacing. When sizes are the same, compared with a charging coil in which narrow-spacing arrangement is not implemented, the charging coil 10 in this implementation contains more metal (for example, copper) per unit area, so that a charging loss is effectively reduced. This helps extend duration in which the charging coil 10 remains at a peak value of 50 W during charging, and improves charging efficiency.

In addition, when outer diameters of charging coils 10 are the same, compared with a charging coil module in which narrow-spacing arrangement is not implemented, in the charging coil 10 in this implementation, both the first coil 12 and the second coil 13 in the charging coil 10 can be arranged at a narrow spacing without reducing sizes of wires in the first coil 12 and the second coil 13, to reduce a thickness of the first coil 12 and/or a thickness of the second coil 13, and reduce an overall thickness of the charging coil 10. In other words, in the charging coil 10 in this implementation, the distance between two adjacent turns of the first coil 12 and the distance between two adjacent turns of the second coil 13 may be reduced to miniaturize the charging coil 10.

FIG. 9 is a partial cross-sectional view of the charging coil module 1 shown in FIG. 3 at a line B-B according to an implementation.

As shown in FIG. 9, the circuit board 20 includes a substrate 21, a first wiring layer 22, a second wiring layer 23, a first insulation layer 24, and a second insulation layer 25. It can be understood that the circuit board 20 may alternatively include more or fewer structures. For example, the circuit board 20 may include more structures. The circuit board 20 may further include a plurality of insulation layers and a plurality of wiring layers. The plurality of insulation layers and the plurality of wiring layers may be alternately stacked on the first wiring layer 22 and/or the second wiring layer 23. For another example, the circuit board 20 may include fewer structures. The circuit board 20 may alternatively not include the first insulation layer 24 and/or the second insulation layer 25 of the circuit board 20.

In an implementation, a material of the substrate 21 of the circuit board 20 may be an insulation material. For example, the substrate 21 of the circuit board 20 includes a three-layer structure, and specifically includes a first PI layer, a bonding layer, and a second PI layer that are sequentially stacked. The bonding layer is made of a polymer insulation bonding sheet (bonding sheet).

In an implementation, both a material of the first wiring layer 22 and a material of the second wiring layer 23 may be metal. For example, both the material of the first wiring layer 22 and the material of the second wiring layer 23 may be copper.

In an implementation, the first insulation layer 24 and the second insulation layer 25 of the circuit board 20 may be made of an insulation material. For example, both the first insulation layer 24 and the second insulation layer 25 of the circuit board 20 are of a two-layer structure, and specifically include a PI layer and an adhesive layer.

As shown in FIG. 9, the substrate 21 of the circuit board 20 may include a first surface 211 and a second surface 212 that are arranged facing away from each other. The first wiring layer 22 may be disposed on the first surface 211 of the substrate 21 of the circuit board 20. The second wiring layer 23 may be disposed on the second surface 212 of the substrate 21 of the circuit board 20. In other words, the substrate 21 of the circuit board 20 is located between the first wiring layer 22 and the second wiring layer 23.

In addition, the first insulation layer 24 of the circuit board 20 may be disposed on the first wiring layer 22 and cover the first wiring layer 22. The second insulation layer 25 of the circuit board 20 may be disposed on the second wiring layer 23 and cover the second wiring layer 23. The first insulation layer 24 of the circuit board 20 may be configured to protect the first wiring layer 22. The second insulation layer 25 of the circuit board 20 may be configured to protect the second wiring layer 23.

It can be understood that the first wiring layer 22 of the circuit board 20 may include a plurality of wires. Two adjacent wires are spaced apart. In this way, when the first insulation layer 24 of the circuit board 20 is disposed on the first wiring layer 22 and covers the first wiring layer 22, the first insulation layer 24 of the circuit board 20 may fill a gap between two adjacent wires. Similarly, for arrangement of the second wiring layer 23 of the circuit board 20, refer to the arrangement of the first wiring layer 22 of the circuit board 20.

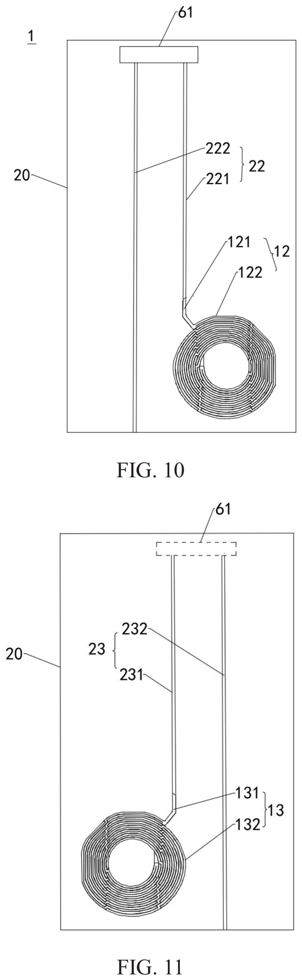

FIG. 10 is a diagram of a partial structure of the charging coil module 1 shown in FIG. 3 according to an implementation. FIG. 11 is a diagram of a structure of the partial charging coil module 1 shown in FIG. 10 at another angle.

As shown in FIG. 10 and FIG. 11, the first wiring layer 22 includes a first wire 221. The second wiring layer 23 includes a second wire 231. The first wire 221 of the first wiring layer 22 and the first leading wire portion 121 of the first coil 12 are of an integrally formed structure. The second wire 231 of the second wiring layer 23 and the second leading wire portion 131 of the second coil 13 are of an integrally formed structure. In this way, one end of the first wire 221 is electrically connected to the first leading wire portion 121 of the first coil 12, and the other end is electrically connected to a BTB connector 61; and one end of the second wire 231 is electrically connected to the second leading wire portion 131 of the second coil 13, and the other end is electrically connected to the BTB connector 61. In this case, the BTB connector 61 may be then electrically connected to the load 4 through another circuit board. It can be understood that the first coil 12 and the second coil 13 may be directly electrically connected to the first wire 221 and the second wire 231 of the circuit board 20, to greatly shorten a charging path between the charging coil 10 and the load 4, and reduce a link loss.

It can be understood that a position of the BTB connector 61 is not limited to positions shown in FIG. 10 and FIG. 11, and the BTB connector 61 may be disposed at any position on the circuit board 20. Specifically, this may be flexibly set according to a requirement. In addition, a position of the load 4 may alternatively be directly arranged on the circuit board 20. In this case, the circuit board 20 may be a main board of the electronic device 100.

In another implementation, the first coil 12 may alternatively be electrically connected to the BTB connector 61 without using the first wire 221. For example, when the circuit board 20 includes more wiring layers, the first coil 12 may alternatively be electrically connected to the BTB connector 61 through a wire of another wiring layer and a via of the circuit board 20. Similarly, the second coil 13 may alternatively be electrically connected to the BTB connector 61 without using the second wire 231. For example, when the circuit board 20 includes more wiring layers, the second coil 13 may alternatively be electrically connected to the BTB connector 61 through a wire of another wiring layer and a via of the circuit board 20.

In an implementation, the first wiring layer 22 may further include a third wire 222. For example, the third wire 222 may be electrically connected between two electronic components, to transmit an electrical signal between the two electronic components. For example, the third wire 222 may alternatively be configured to provide a wired power supply path for the load 4.

In an implementation, a wire width of the third wire 222 may be greater than or equal to 40 micrometers. For example, the wire width of the third wire 222 is equal to 40 micrometers.

In another implementation, the first wiring layer 22 may alternatively not include the third wire 222.

In an implementation, the second wiring layer 23 includes a fourth wire 232. The fourth wire 232 and the third wire 222 may be disposed in similar manners or a same manner. Details are not described herein again.

As shown in FIG. 8 and FIG. 9, the substrate 21 of the circuit board 20 and the substrate 11 of the charging coil 10 are disposed at a same layer, and are of an integrally formed structure. The substrate 21 of the circuit board 20 and the substrate 11 of the charging coil 10 may be formed through a same step. For example, the first PI layer of the substrate 11 of the charging coil 10 and the first PI layer of the substrate 21 of the circuit board 20 are disposed at a same layer, and are of an integrally formed structure. The bonding layer of the substrate 11 of the charging coil 10 and the bonding layer of the substrate 21 of the circuit board 20 are disposed at a same layer, and are of an integrally formed structure. The second PI layer of the substrate 11 of the charging coil 10 and the second PI layer of the substrate 21 of the circuit board 20 are disposed at a same layer, and are of an integrally formed structure.

As shown in FIG. 8 and FIG. 9, the first wiring layer 22 of the circuit board 20 and the first coil 12 of the charging coil 10 may be disposed at a same layer. In this case, the first wiring layer 22 of the circuit board 20 and the first coil 12 of the charging coil 10 may be formed through a same process step. The first wire 221 of the first wiring layer 22 and the first leading wire portion 121 of the first coil 12 of the charging coil 10 are of an integrally formed structure.

As shown in FIG. 8 and FIG. 9, the second wiring layer 23 of the circuit board 20 and the second coil 13 of the charging coil 10 may be disposed at a same layer. In this case, the second wiring layer 23 of the circuit board 20 and the second coil 13 of the charging coil 10 may be formed through a same process step. The second wire 231 of the second wiring layer 23 and the second leading wire portion 131 of the second coil 13 are of an integrally formed structure.

As shown in FIG. 9 and FIG. 4, the first insulation layer 24 of the circuit board 20 and the first insulation layer 14 of the charging coil 10 may be disposed at a same layer. The first insulation layer 24 of the circuit board 20 and the first insulation layer 14 of the charging coil 10 are of an integrally formed structure. In this case, the first insulation layer 24 of the circuit board 20 and the first insulation layer 14 of the charging coil 10 may be formed through a same process step.

As shown in FIG. 9 and FIG. 4, the second insulation layer 25 of the circuit board 20 and the second insulation layer 15 of the charging coil 10 may be disposed at a same layer. The second insulation layer 25 of the circuit board 20 and the second insulation layer 15 of the charging coil 10 are of an integrally formed structure. In this case, the second insulation layer 25 of the circuit board 20 and the second insulation layer 15 of the charging coil 10 may be formed through a same process step.

It can be understood that the substrate 21 of the circuit board 20 and the substrate 11 of the charging coil 10 are disposed at a same layer, the first wiring layer 22 and the first coil 12 are disposed at a same layer, and the second wiring layer 23 and the second coil 13 are disposed at a same layer, so that the charging coil 10 and the circuit board 20 form an integrated structure, and the charging coil module 1 has good structural strength. In this way, compared with a solution in which the charging coil 10 is stacked on the circuit board 20, in this implementation, there is an overlapping region between the charging coil 10 and the circuit board 20 along a thickness direction, so that a thickness of the charging coil module 1 can be greatly reduced.

It can be understood that, compared with a solution in which the charging coil 10 and the circuit board 20 are separately prepared and then the charging coil 10 is connected to the circuit board 20 through a BTB connector, in this implementation, the circuit board 20 may be prepared during preparation of the charging coil 10, or the charging coil 10 may be prepared during preparation of the circuit board 20. This can omit one process of preparing the charging coil 10 or the circuit board 20, to reduce costs of the charging coil module 1. In addition, the charging coil 10 and the circuit board 20 are disposed to be of an integrated structure, so that a step of assembling the charging coil module 1 can be omitted, to reduce difficulty in preparing the charging coil module 1.

In addition, compared with a case in which the first coil 12 and the second coil 13 are electrically connected to the circuit board 20 through a BTB connector, in this implementation, the first coil 12 and the second coil 13 may be directly electrically connected to a wire on the circuit board 20 (for example, a wire at the first wiring layer 22 of the circuit board 20 or a wire at the second wiring layer 23 of the circuit board 20). This can shorten a charging path between the charging coil 10 and the load 4, to reduce a link loss. In addition, the BTB connector can be omitted, to simplify a structure of the charging coil module 1, and reduce costs of the charging coil module 1.

It can be understood that the first insulation layer 14 of the charging coil 10 and the first insulation layer 24 of the circuit board 20 are disposed at a same layer, so that the first insulation layer 24 of the circuit board 20 can be prepared during preparation of the first insulation layer 14 of the charging coil 10, or the first insulation layer 14 of the charging coil 10 can be prepared during preparation of the first insulation layer 24 of the circuit board 20. This can omit one process of preparing the first insulation layer 14 of the charging coil 10 or the first insulation layer 24 of the circuit board 20, to reduce costs of the charging coil module 1.

It can be understood that, when the charging coil module 1 achieves higher wireless charging efficiency through a reduction in a link loss, the first coil 12 and the second coil 13 in the charging coil 10 can be arranged at a narrow spacing. When sizes are the same, compared with a charging coil 10 in which narrow-spacing arrangement is not implemented, the charging coil 10 in this implementation contains more metal (for example, copper) per unit area, so that a charging loss is effectively reduced. This helps extend duration in which the charging coil 10 remains at a peak value of 50 W during charging, and improves charging efficiency.

It can be understood that, when the charging coil module 1 achieves higher wireless charging efficiency through a reduction in a link loss, the first coil 12 and the second coil 13 in the charging coil 10 can be arranged at a narrow spacing, a large thickness (for example, the thickness is greater than 40 micrometers), and a large wire width (for example, the wire width is greater than 40 micrometers). This helps reduce impedance of a charging path. For example, compared with charging impedance (for example, 45.2 ohms) of a conventional charging coil module, charging impedance of the charging coil module 1 in this implementation can be reduced to 25.6 ohms, with a reduction of approximately 43%. In addition, a heat dissipation capability of the charging coil module 1 can also be improved.

The foregoing specifically describes a specific structure of the charging coil module 1 in this application. The following specifically describes a preparation process for the charging coil module 1 with reference to the accompanying drawings.

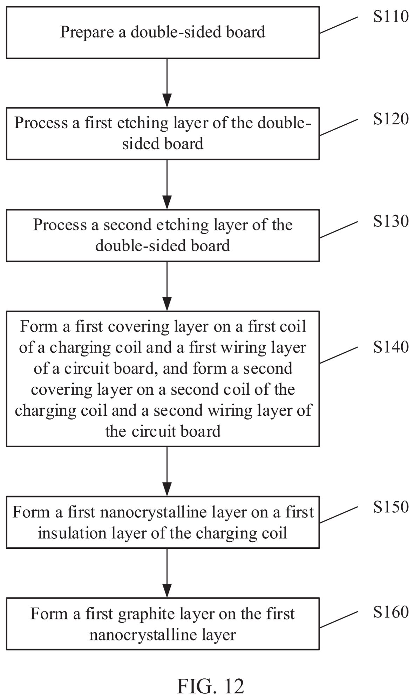

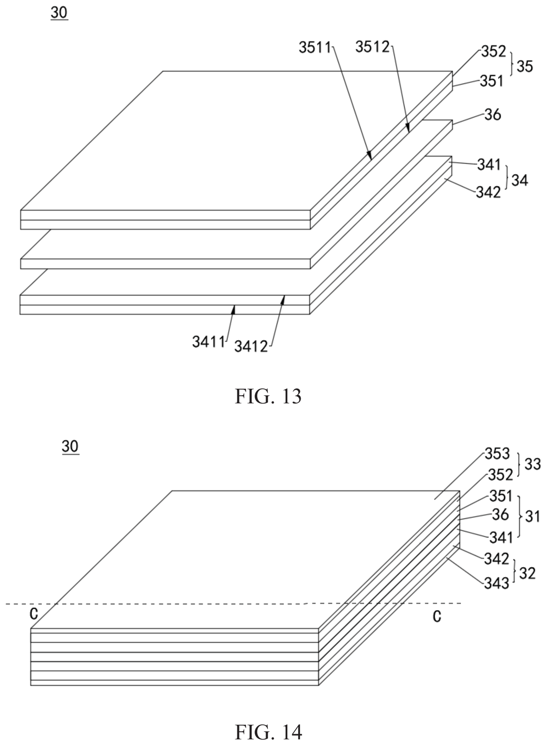

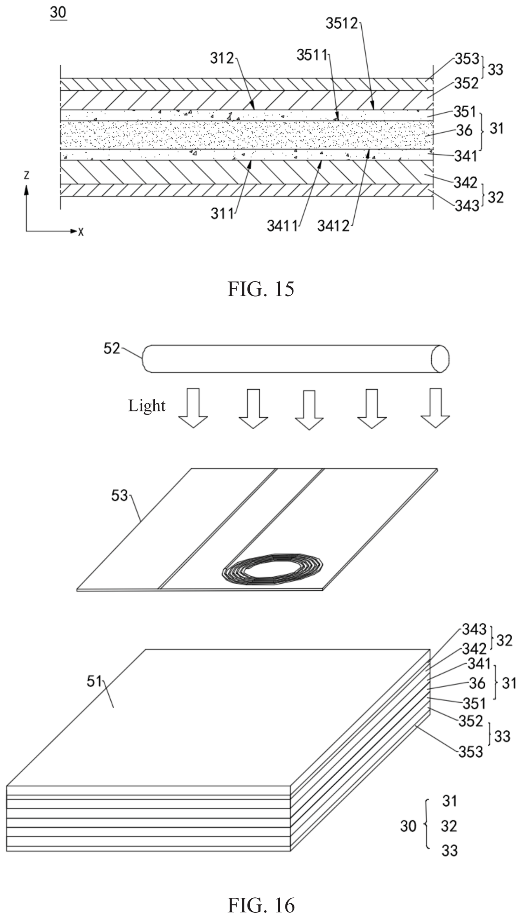

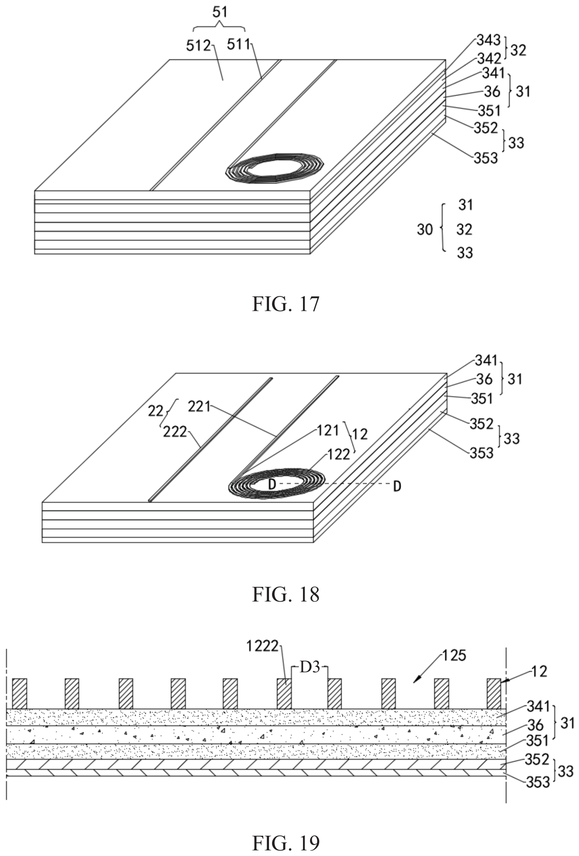

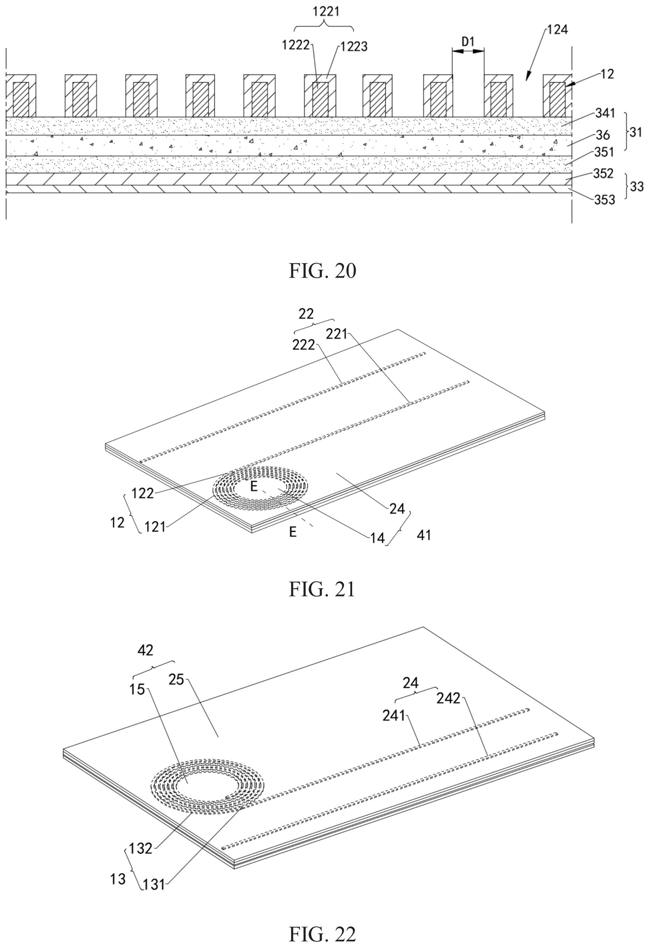

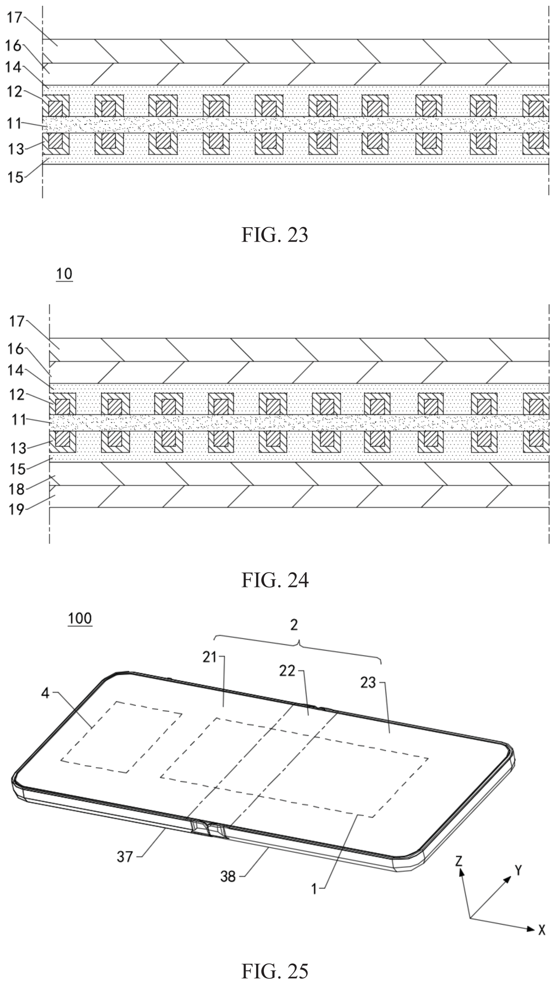

FIG. 12 is a flowchart of preparing the charging coil module 1 shown in FIG. 3. FIG. 13 to FIG. 23 are diagrams 1 to 11 of structures of some steps of a preparation method for the charging coil module 1 shown in FIG. 12 according to some embodiments. FIG. 15 is a partial cross-sectional view of a double-sided board 30 shown in FIG. 14 at a line C-C according to an implementation. FIG. 19 is a partial cross-sectional view of a mechanical part shown in FIG. 18 at a line C-C according to an implementation. FIG. 20 is a partial cross-sectional view of a second conducting portion 1223 formed on a first conducting portion 1222 shown in FIG. 19. FIG. 23 is a partial cross-sectional view of a first nanocrystalline layer 16 and a first graphite layer 17 that are formed on a first insulation layer 14 shown in FIG. 21.

The preparation process for the charging coil module 1 includes but is not limited to steps S110 to S160 shown in FIG. 12.

S110: Prepare a double-sided board 30. As shown in FIG. 13 to FIG. 15, the double-sided board 30 includes a substrate 31, a first etching layer 32, and a second etching layer 33. The first etching layer 32 and the second etching layer 33 are respectively disposed on a first surface 311 and a second surface 312 of the substrate 31. The first surface 311 and the second surface 312 of the substrate 31 of the double-sided board 30 are arranged facing away from each other. The substrate 31 of the double-sided board 30 is formed as a substrate 11 of a charging coil 10 (refer to FIG. 8) and a substrate 21 of a circuit board 20 (refer to FIG. 9).

For example, in the step of preparing the double-sided board 30, step S110 further includes the following sub-steps.

A first substrate 341 of a first flexible copper clad laminate (FCCL) 34 and a second substrate 351 of a second flexible copper clad laminate 35 are bonded to two surfaces of a bonding sheet 36, where the first flexible copper clad laminate 34 includes the first substrate 341 and a first metal layer 342, the first metal layer 342 is disposed on a first surface 3411 of the first substrate 341, the second flexible copper clad laminate 35 includes the second substrate 351 and a second metal layer 352, the second metal layer 352 is disposed on a first surface 3511 of the second substrate 351, and a second surface 3412 of the first substrate 341 and a second surface 3512 of the second substrate 351 are bonded to the two surfaces of the bonding sheet 36.

For example, both a material of the first substrate 341 and a material of the second substrate 351 may be insulation materials, for example, polyester film or polyimide (PI). Both a material of the first metal layer 342 and a material of the second metal layer 352 may be copper.

For example, a weight of the first metal layer 342 of the first flexible copper clad laminate 34 may be one-third of an ounce (oz), and a weight of the second metal layer 352 of the second flexible copper clad laminate 35 may be one-third of an ounce (oz).

For example, along a Z-axis direction, a thickness of the first substrate 341 of the first flexible copper clad laminate 34 is less than or equal to 12.5 micrometers, and a thickness of the second substrate 351 of the second flexible copper clad laminate 35 is less than or equal to 12.5 micrometers.

For example, a material of the bonding sheet 36 may be a sticky polymer material.

For example, along the Z-axis direction, a thickness of the bonding sheet is less than or equal to 15 micrometers.

The first flexible copper clad laminate 34, the bonding sheet 36, and the second flexible copper clad laminate 35 are press-fit to form the double-sided board 30.

In an implementation, the first flexible copper clad laminate 34, the bonding sheet 36, and the second flexible copper clad laminate 35 may be pressed into a whole through a thermal compression bonding process, a pressure transfer process, a rapid pressure bonding process, a vacuum press-fitting process, or the like, to form a double-sided board 30 of a firm and stable structure.

It can be understood that the first substrate 341 of the first flexible copper clad laminate 34, the bonding sheet 36, and the second substrate 351 of the second flexible copper clad laminate 35 form the substrate 31 of the double-sided board 30, namely, the substrate 11 of the charging coil 10 and the substrate 21 of the circuit board 20.

For example, the first substrate 341 of the first flexible copper clad laminate 34 may form a first PI layer of the substrate 11 of the charging coil 10 and a first PI layer of the substrate 21 of the circuit board 20, the bonding sheet 36 may form a bonding layer of the substrate 11 of the charging coil 10 and a bonding layer of the substrate 21 of the circuit board 20, and the second substrate 351 of the second flexible copper clad laminate 35 may form a second PI layer of the substrate 11 of the charging coil 10 and a second PI layer of the substrate 21 of the circuit board 20.

It can be understood that the first metal layer 342 of the first flexible copper clad laminate 34 forms the first etching layer 32 of the double-sided board 30, and the second metal layer 352 of the second flexible copper clad laminate 35 forms the second etching layer 33 of the double-sided board 30.

For example, in the step of preparing the double-sided board 30, step S110 further includes: providing holes on the double-sided board 30 to form a plurality of vias. Each via may pass through the first metal layer 342 of the first flexible copper clad laminate 34 to the second metal layer 352 of the second flexible copper clad laminate 35. The via may be used to implement an electrical connection between the first metal layer 342 of the first flexible copper clad laminate 34 and the second metal layer 352 of the second flexible copper clad laminate 35.

For example, in the step of preparing the double-sided board 30, step S110 further includes: performing operations such as preprocessing and microetching on the double-sided board 30, to facilitate subsequent preparation. For example, the preprocessing may be: removing contaminants from the first metal layer 342 and the second metal layer 352 by using a brush wheel, to increase surface roughness of the first metal layer 342 and the second metal layer 352; and the microetching may be: increasing surface roughness of the first metal layer 342 and the second metal layer 352 through chemical corrosion.

As shown in FIG. 14 and FIG. 15, for example, in the step of preparing the double-sided board 30, step S110 further includes: forming a third metal layer 343 on the first metal layer 342 of the first flexible copper clad laminate 34 through electroplating, where the first metal layer 342 and the third metal layer 343 form the first etching layer 32; and/or forming a fourth metal layer 353 on the second metal layer 352 of the second flexible copper clad laminate 35 through electroplating, where the second metal layer 352 and the fourth metal layer 353 form the second etching layer 33.

It can be understood that the third metal layer 343 is formed on the first metal layer 342 of the first flexible copper clad laminate 34 through electroplating by using an electroplating process, to increase a thickness of the first metal layer 342, to satisfy a thickness needed for etching and facilitate a subsequent process operation.

It can be understood that the fourth metal layer 353 is formed on the second metal layer 352 of the second flexible copper clad laminate 35 through electroplating by using an electroplating process, to increase a thickness of the second metal layer 352, to satisfy a thickness needed for etching and facilitate a subsequent process operation.

For example, along the Z-axis direction, a thickness of the first etching layer 32 may range from 10 micrometers to 60 micrometers. For example, the thickness of the first etching layer 32 may be 10 micrometers, 20 micrometers, 25 micrometers, 30 micrometers, 42 micrometers, or 60 micrometers.

For example, along the Z-axis direction, a thickness of the second etching layer 33 ranges from 10 micrometers to 60 micrometers. For example, the thickness of the second etching layer 33 may be 10 micrometers, 20 micrometers, 25 micrometers, 30 micrometers, 42 micrometers, or 60 micrometers.

S120: Process the first etching layer 32 of the double-sided board 30 to form a first coil 12 of the charging coil 10 and a first wiring layer 22 of the circuit board 20. As shown in FIG. 10, the first coil 12 includes a first leading wire portion 121, the first wiring layer 22 includes a first wire 221, and the first leading wire portion 121 and the first wire 221 are of an integrally formed structure.

As shown in FIG. 16 to FIG. 19, for example, in the step of processing the first etching layer 32 of the double-sided board 30, step S120 includes a film application process, an exposure process, a development process, an etching process, a film removal process, and the like. For example, the film application process may be: applying a first photoresist layer 51 to the first etching layer 32 of the double-sided board 30. The exposure process may be: performing exposure on the first etching layer 32 by using a light source 52 through a mask 53. In this way, a first pattern 511 and a second pattern 512 are formed on the first photoresist layer 51. The first pattern 511 has been illuminated by light. The second pattern 512 has not been illuminated by light. In addition, the first pattern 511 is a pattern including the first coil 12 and the first wiring layer 22. The development process may be: removing the first pattern 511 or the second pattern 512 by using a developer. It can be understood that whether the first pattern 511 or the second pattern 512 is to be removed by using the developer depends on a material and a structure of the first photoresist layer 51. Specifically, a choice may be made according to a requirement. In this implementation, an example in which the second pattern 512 is removed by using the developer is used for description. The etching process may be a plasma etching process. Specifically, a part, exposed relative to the first photoresist layer 51, of the first etching layer 32 is etched, in other words, a part, opposite to the second pattern 512, of the first etching layer 32 is etched, so that a part, opposite to the first pattern 511, of the first etching layer 32 remains after the etching. The film removal process may be: removing the first pattern 511 of the first etching layer 32 to expose the part, opposite to the first pattern 511, of the first etching layer 32. For example, the first pattern 511 of the first photoresist layer 51 may be removed by using a stripper, to expose the part, opposite to the first pattern 511, of the first etching layer 32. It can be understood that a remaining part of the first etching layer 32 may form the first coil 12 of the charging coil 10 and the first wiring layer 22 of the circuit board 20. In this implementation, an electroplating process is further performed after film removal. Therefore, in this implementation, after the film application process, the exposure process, the development process, the etching process, the film removal process, and the like are performed, a remaining part of the first etching layer 32 may form a first conducting portion 1222 of the first coil 12 of the charging coil 10 and a part of the first wiring layer 22 of the circuit board 20.

As shown in FIG. 19, a third gap 125 is formed in a space between first conducting portions 1222 of two adjacent first coils 12. A spacing D3 between first conducting portions 1222 of two adjacent first coils 12 may be a minimum width of the third gap 125. For example, the spacing D3 between first conducting portions 1222 of two adjacent first coils 12 may range from 60 micrometers to 100 micrometers. In an implementation, the spacing D3 between first conducting portions 1222 of two adjacent first coils 12 may be 80 micrometers.

It can be understood that, during the film application process, the exposure process, the development process, the etching process, the film removal process, and the like of the first etching layer 32 of the double-sided board 30, a larger thickness of metal that needs to be etched indicates greater lateral etching during etching and a larger width of a finally formed gap (namely, a first gap). In this implementation, a thin first etching layer 32 is etched, to effectively mitigate lateral etching, reduce a width of a formed gap, and help control etching quality of the first coil 12. In addition, a smaller thickness of to-be-etched metal indicates shorter time needed for etching. This helps improve production efficiency.

In another implementation, a thick first etching layer 32 may alternatively be etched. A width of a third gap 125 formed through etching may range from 100 micrometers to 130 micrometers. In an implementation, the width of the third gap 125 may be 120 micrometers.

As shown in FIG. 20, for example, in the step of processing the first etching layer 32 of the double-sided board 30, step S120 further includes an electroplating process. For example, the electroplating process may be: performing electroplating on the first conducting portion 1222 of the first coil 12 of the charging coil 10 to form a second conducting portion 1223 of the first coil 12. For example, the electroplating process may be leading wire electroplating.

It can be understood that a first gap 124 is formed in a space between second conducting portions 1223 of two adjacent first coils 12. A spacing D1 between second conducting portions 1223 of two adjacent first coils 12 may be a minimum width of the first gap 124.

For example, the spacing D1 between second conducting portions 1223 of two adjacent first coils 12 may range from 40 micrometers to 60 micrometers. In this case, a width of the formed first gap 124 of the first coil 12 is small. In an implementation, the spacing D1 between second conducting portions 1223 of two adjacent first coils 12 may be 55 micrometers.

It can be understood that electroplating is performed on the first conducting portion 1222 of the first coil 12 of the charging coil 10 to form the second conducting portion 1223 of the first coil 12, to reduce the width of the third gap D3, in other words, form the first gap D1 with a small width. In this way, compared with a solution of a charging coil 10 in which a wire is directly formed through etching, in this implementation, the first coil 12 of the charging coil 10 is electroplated, so that a spacing between two adjacent first conducting portions 1222 can be significantly reduced, to obtain the first coil 12, arranged at a narrow spacing, of the charging coil 10.

It can be understood that, when outer diameters of first coils 12 of charging coils 10 are the same, compared with a charging coil in which narrow-spacing arrangement is not implemented, in the first coil 12 of the charging coil 10 in this implementation, a thickness of the first coil 12 can be reduced by reducing the width of the third gap D3 of the first coil 12 without reducing a size of a wire in the first coil 12, to reduce an overall thickness of the charging coil 10 and facilitate thinning of the charging coil 10.

In addition, when sizes of charging coils 10 are the same, compared with a charging coil in which narrow-spacing arrangement is not implemented, the charging coil 10 in this implementation contains more metal (for example, copper) per unit area, and a size of a wire in the charging coil 10 can be larger, so that a charging loss can be reduced. This helps extend duration in which the charging coil 10 remains at a peak value of 50 W during charging, and improves charging efficiency.

As shown in FIG. 14 to FIG. 20, in this implementation, in step S110, the third metal layer 343 is formed on the first metal layer 342 of the first flexible copper clad laminate 34 through electroplating by using the electroplating process, to increase the thickness of the first metal layer 342. To be specific, the thickness of the first etching layer 32 formed by the first metal layer 342 and the third metal layer 343 is large. In this way, after the first etching layer 32 is processed to form the first conducting portion 1222 of the first coil 12, because the thickness of the first etching layer 32 remains unchanged during processing, a thickness of the first conducting portion 1222, formed through processing, of the first coil 12 also remains unchanged. In this way, the thickness of the first conducting portion 1222, formed through processing, of the first coil 12 is also large. In this case, during forming of the second conducting portion 1223 of the first coil 12 on the first conducting portion 1222 of the first coil 12 of the charging coil 10 through electroplating, a thickness of the second conducting portion 1223 of the first coil 12 does not need to be excessively large during electroplating. It can be understood that, during forming of the second conducting portion 1223 of the first coil 12 through electroplating, each time metal with a thickness of 20 micrometers is formed, a thickness tolerance that occurs during preparation of the metal with a thickness of 20 micrometers is approximately ±8 micrometers. In this implementation, the thick first conducting portion 1222 of the first coil 12 is directly electroplated, to reduce a thickness error during second electroplating, so that the thickness of the formed second conducting portion 1023 of the first coil 12 is more uniform.

It can be understood that, although the first coil 12 of the charging coil 10 is electroplated in the foregoing electroplating process, in another implementation, the first wiring layer 22 of the circuit board 20 may alternatively be electroplated, to enable the first wiring layer 22 of the circuit board 20 to contain more metal (for example, copper) per unit area, increase a size of a wire at the first wiring layer 22 of the circuit board 20, and reduce a charging loss.

In another implementation, in the step of processing the first etching layer 32 of the double-sided board 30, step S120 may alternatively not include an electroplating process. In this case, after the first etching layer 32 of the double-sided board 30 undergoes the film application process, the exposure process, the development process, the etching process, the film removal process, and the like, a remaining part of the first etching layer 32 directly forms the first coil 12 of the charging coil 10 and the first wiring layer 22 of the circuit board 20. Details are not described herein again.

S130: Process the second etching layer 33 of the double-sided board 30 to form a second coil 13 of the charging coil 10 and a second wiring layer 23 of the circuit board 20. As shown in FIG. 11, the second coil 13 includes a second leading wire portion 131, the second wiring layer 23 includes a second wire 231, and the second leading wire portion 131 and the second wire 231 are of an integrally formed structure.

For example, in the step of processing the second etching layer 33 of the double-sided board 30, step S130 includes film application, exposure, development, etching, and film removal. For processes of the film application, the exposure, the development, the etching, and the film removal, refer to the film application, the exposure, the development, the etching, and the film removal in S120. Details are not described herein again.

For example, in the step of processing the second etching layer 33 of the double-sided board 30, step S130 may further include an electroplating process. For the electroplating process, refer to the electroplating process in S120. Details are not described herein again.

It can be understood that the electroplating process in step S130 and the electroplating process in step S120 may be performed simultaneously.

S140: Form a first covering layer 41 on the first coil 12 of the charging coil 10 and the first wiring layer 22 of the circuit board 20, and form a second covering layer 42 on the second coil 13 of the charging coil 10 and the second wiring layer 23 of the circuit board 20. As shown in FIG. 21 and FIG. 22, the first covering layer 41 covers the first coil 12 of the charging coil 10 and the first wiring layer 22 of the circuit board 20, and the second covering layer 42 covers the second coil 13 of the charging coil 10 and the second wiring layer 23 of the circuit board 20. It can be understood that the first covering layer 41 is formed as a first insulation layer 14 of the charging coil 10 and a first insulation layer 24 of the circuit board 20, and the second covering layer 42 is formed as a second insulation layer 15 of the charging coil 10 and a second insulation layer 25 of the circuit board 20.

It can be understood that, because the first coil 12 of the charging coil 10 and the first wiring layer 22 of the circuit board 20 are covered by the first covering layer 41, and the second coil 13 of the charging coil 10 and the second wiring layer 23 of the circuit board 20 are covered by the second covering layer 42, FIG. 21 shows the first coil 12 of the charging coil 10, the first wiring layer 22 of the circuit board 20, the second coil 13 of the charging coil 10, and the second wiring layer 23 of the circuit board 20 by using dashed lines.

For example, a material of the first covering layer 41 is an insulation material. The first covering layer 41 is a two-layer structure. A first layer of the first covering layer 41 may be PI. A second layer of the first covering layer 41 may be adhesive (adhesive, AD). The second layer of the first covering layer 41 is bonded to the first coil 12 of the charging coil 10 and the first wiring layer 22 of the circuit board 20. The first covering layer 41 is configured to protect the first coil 12 of the charging coil 10 and the first wiring layer 22 of the circuit board 20.

For example, a material of the second covering layer 42 is an insulation material. The second covering layer 42 is a two-layer structure. A first layer of the second covering layer 42 may be PI. A second layer of the second covering layer 42 may be adhesive (adhesive, AD). The second layer of the second covering layer 42 is bonded to the second coil 13 of the charging coil 10 and the second wiring layer 23 of the circuit board 20. The second covering layer 42 is configured to protect the second coil 13 of the charging coil 10 and the second wiring layer 23 of the circuit board 20.

For example, a color of the first covering layer 41 and/or a color of the second covering layer 42 may be black.

For example, after the step of forming the first covering layer 41 on the first coil 12 of the charging coil 10 and the first wiring layer 22 of the circuit board 20, and forming the second covering layer 42 on the second coil 13 of the charging coil 10 and the second wiring layer 23 of the circuit board 20, the first covering layer 41 and/or the second covering layer 42 are/is press-fit.

In an implementation, the first covering layer 41 and/or the second covering layer 42 may be press-fit through a thermal compression bonding process, a pressure transfer process, a rapid pressure bonding process, a vacuum press-fitting process, or the like to form a charging coil module 1 of a firm and stable structure.

S150: Form a first nanocrystalline layer 16 on the first insulation layer 14 of the charging coil 10.

For example, the first nanocrystalline layer 16 may be bonded to the first insulation layer 14 of the charging coil 10 through an adhesive layer. The adhesive layer may be double-sided adhesive.

S160: Form a first graphite layer 17 on the first nanocrystalline layer 16.

For example, the first graphite layer 17 may be connected, through bonding and press-fitting, to a surface, away from the first insulation layer 14, of the first nanocrystalline layer 16.

It can be understood that, before the charging coil module 1 is prepared by using the preparation method in this implementation, target parameters, such as a structure and a material, of the charging coil module 1 may be input to electrical simulation software, and an electromagnetic field is added to perform monomer simulation, to obtain simulated direct current impedance of the charging coil module 1. Then parameters, such as a wire spacing of the first coil 12, a wire spacing of the second coil 1313, a thickness of the first nanocrystalline layer 16, and a thickness of the first graphite layer 17, in the charging coil module 1 are adjusted based on obtained simulated values, to enable a charging coil module 1 obtained through adjustment to meet a design requirement. For example, the simulated direct current impedance of the charging coil module 1 may be 98.7 mΩ. Direct current impedance of a charging coil module 1 that meets a design requirement for an inductance of 3.49 µH and a power of 50 W is less than or equal to 100 mΩ. In other words, the charging coil module 1 prepared by using the preparation method in this application can meet a general design requirement.

It can be understood that both the first coil 12 and the second coil 13 of the charging coil module 1 in this application can be arranged at a narrow spacing. When outer diameters of charging coil modules 1 are the same, compared with a solution of a conventional charging coil module in which narrow-spacing arrangement is not implemented, the charging coil module 1 in this application may have same direct current resistance (Remote Differential Compression, RDC) and same power as the conventional charging coil module, but have a smaller overall thickness. In other words, when the charging coil module 1 in this application meets a power requirement of the conventional charging coil module, an overall thickness of the charging coil module 1 can be reduced, to miniaturize the charging coil module 1. The thickness of the charging coil module 1 may be reduced by approximately 20 micrometers to 70 micrometers. In this way, when the charging coil module 1 in this application is used in an electronic device 100, for example, a mobile phone, with a limited internal space, the overall thickness of the charging coil module 1 can be reduced to better meet a thinning requirement of the electronic device 100.

In addition, compared with the solution of the conventional charging coil module 1 in which narrow-spacing arrangement is not implemented, in this implementation, impedance of the charging coil module 1 can be reduced by approximately 17%. When power (for example, 50 W) of the charging coil module 1 is the same as power of the conventional charging coil module, the charging coil module 1 in this implementation has a smaller charging loss, and duration for retaining a peak value of 50 W during charging increases.

In some implementations, automated optical inspection (Automated Optical Inspection, AOI) may be further performed in step S120 and step S130 to reduce product defects and increase a product yield.

In some implementations, in step S140, the charging coil module 1 provided with the first insulation layer 14 and the second insulation layer 15 may be further processed. For example, operations such as press-fitting, adhesive scrap removal, sandblasting, immersion gold, hot water washing, spray silkscreen, baking silkscreen, electrical measurement, cutting, and warehousing detection may be further sequentially performed on the charging coil module 1 covered with the first insulation layer 14 and the second insulation layer 15.

In some implementations, during preparation of the charging coil module 1, a copper sheet (not shown in the figure) may be further disposed around the first conducting portion 1222 of the first coil 12. The copper sheet may be spaced away from the first conducting portion 1222 of the first coil 12. In this way, a uniform current can be implemented through the copper sheet during subsequent electroplating. Compared with the charging coil module 1 in which no copper sheet is disposed around the first conducting portion 1222 of the first coil 12, in the charging coil module 1 in this implementation, an electroplating area can be increased by the copper sheet, to implement a uniform current and reduce current density for forming the first coil 12 and the second coil 13, so that electroplating is more uniform. This helps increase a product yield. It can be understood that the copper sheet may be removed after the preparation of the charging coil module 1 is completed, in other words, the prepared charging coil module 1 may not include the copper sheet.

In some implementations, an electroplating parameter in S120 and step S130 may alternatively be adjusted to change an electroplating speed and optimize an electroplating leading wire. The electroplating parameter may be current density or electroplating time. For example, current density of the first conducting portion 1222 of the first coil 12 and current density of the first conducting portion 1322 of the second coil 13 may be set in a differentiated manner. For example, electroplating density of the first conducting portion 1222 of the first coil 12 may be 2.3 ADS, and electroplating density of the first conducting portion 1321 of the second coil 13 may be 2.5 ADS. The ADS is a unit of the current density, and stands for ampere per square decimeter. In this case, the current density of the first conducting portion 1222 of the first coil 12 is less than the current density of the first conducting portion 1322 of the second coil 13. In this way, the current density of the first conducting portion 1222 of the first coil 12 is reduced, to make a first coil 12 obtained through electroplating have a more uniform thickness. This helps increase a product yield.

In some implementations, in step S150, another electrical element may be further disposed in the charging coil module 1 by using a surface mount technology (Surface Mount Technology, SMT). Before a reflow soldering step of the surface mount technology, during surface mounting of the substrate 11 of the charging coil 10, the substrate 11 of the charging coil 10 may be clamped by using a magnetic fixture, to disperse heat. This can reduce a risk of blistering during forming of the first insulation layer 14 and the second insulation layer 15, and increase a product yield.

In some implementations, in step S140, during washing of the charging coil module 1 covered with the first insulation layer 14 and the second insulation layer 15, any end of the substrate 11 of the charging coil 10 may be placed on a guide plate to go through a cleaning section. In this way, the guide plate is disposed to support the substrate 11 of the charging coil 10 and provide guidance for transferring the substrate 11 of the charging coil 10. This can effectively reduce a risk of wrinkling or creasing during washing, and help increase a product yield.

The foregoing describes a structure of a charging coil 10 and a preparation method for the charging coil 10 with reference to related accompanying drawings. The following further describes a structure of a charging coil 10 and a preparation method for the charging coil 10 with reference to related accompanying drawings.

FIG. 24 is a partial cross-sectional view of the charging coil module 1 shown in this implementation according to another implementation. For example, FIG. 24 is a partial cross-sectional view of a second nanocrystalline layer 18 and a second graphite layer 19 that are formed on the second insulation layer 15 shown in FIG. 22.

In this implementation, a structure of the charging coil module 11 is approximately the same as the structure of the charging coil module 1 shown in FIG. 23, and same technical content is not described herein again. As shown in FIG. 24, the charging coil 10 may further include the second nanocrystalline layer 18 and the second graphite layer 19. The second nanocrystalline layer 18 and the second graphite layer 19 are sequentially stacked on the second insulation layer 15. For a material of the second nanocrystalline layer 18 and a material of the second graphite layer 19, refer to the arrangement of the first nanocrystalline layer and the second graphite layer 19. Details are not described herein again.

For example, the second nanocrystalline layer 18 may be bonded, through an adhesive layer, to a surface, away from the second coil 13, of the second insulation layer 15 of the charging coil 10; and the second graphite layer 19 may be connected, through bonding and press-fitting, to a surface, away from the second insulation layer 15, of the second nanocrystalline layer 18. In this way, the second nanocrystalline layer 18 and the second graphite layer 19 are disposed, so that sizes of nanocrystal and graphite in the charging coil module 1 are increased. This effectively increases charging power of the charging coil module 1.

It can be understood that, in this implementation, a preparation method for the charging coil module 1 is approximately the same as the preparation method for the charging coil module 1 shown in FIG. 23, and same technical content is not described herein again.

In S150, after the first nanocrystalline layer 16 is formed, the second nanocrystalline layer 18 may be formed on the second insulation layer 15 of the charging coil 10. For example, the second nanocrystalline layer 18 may be bonded to the second insulation layer 15 of the charging coil 10 through an adhesive layer. Certainly, the second nanocrystalline layer 18 may alternatively be formed on the second insulation layer 15 of the charging coil 10 during forming of the first nanocrystalline layer 16.

In S160, after the first graphite layer 17 is formed, the second graphite layer 19 may be formed on the second nanocrystalline layer 18. For example, the second graphite layer 19 may be connected, through bonding and press-fitting, to the surface, away from the second insulation layer 15, of the second nanocrystalline layer 18. Certainly, the second graphite layer 19 may alternatively be formed on the second nanocrystalline layer 18 during forming of the first graphite layer 17.

The foregoing specifically describes a structure of a charging coil module 1 and a preparation method for the charging coil module 1 with reference to related accompanying drawings. The charging coil module 1 may be used in a bar-type device, namely, a non-foldable electronic device. The following specifically describes a structure of another charging coil module 1 and a preparation method for the charging coil module 1 with reference to related accompanying drawings. The charging coil module 1 may be used in a foldable device, to be specific, an electronic device that can be folded. Technical content that is the same as that in the foregoing descriptions is not described herein again.

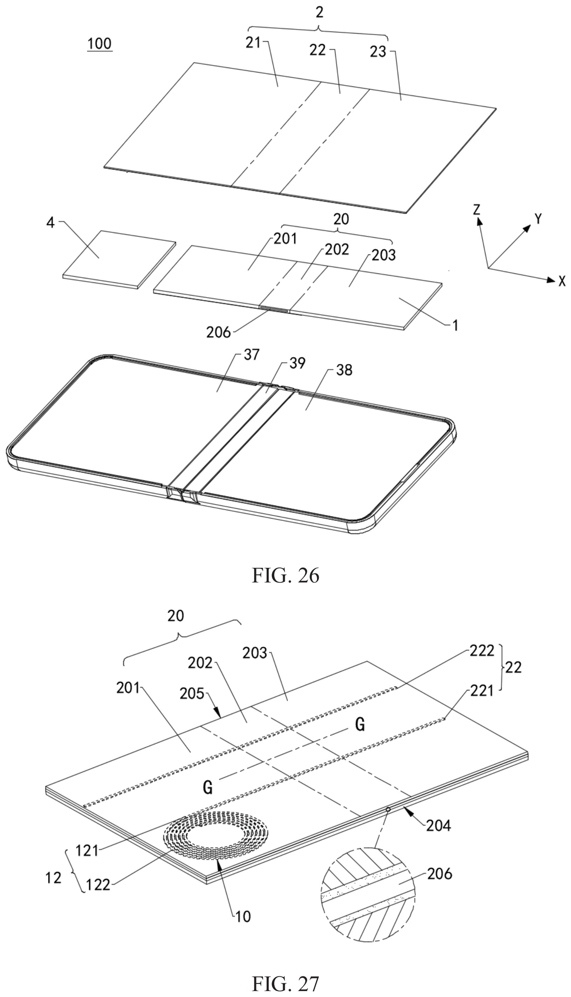

FIG. 25 is a diagram of a structure of an electronic device 100 in an unfolded state in an implementation according to an embodiment of this application. As shown in FIG. 25, the electronic device 100 provided in this application is a foldable electronic device 100. The foldable electronic device 100 may be a mobile phone, a tablet computer, a personal computer, a notebook computer, a vehicle-mounted device, a wearable device, or another device that can be folded. In an embodiment shown in FIG. 25 and FIG. 26, an example in which the foldable electronic device 100 is a mobile phone is used for description. It can be understood that the electronic device 100 is not limited to being folded once as shown in FIG. 25 and FIG. 26, in other words, the electronic device 100 is not limited to a single-fold electronic device 100 shown in FIG. 25. In another implementation, the electronic device 100 may be folded more than once, in other words, the electronic device 100 may be a double (or more)-fold electronic device 100.

For ease of description, for example, a thickness direction of the electronic device 100 is defined as a Z-axis direction, and an extension direction of a rotation axis of the electronic device 100 is defined as a Y-axis direction, that is, a width direction of the electronic device 100 is defined as the Y-axis direction. A direction perpendicular to the Y-axis direction and the Z-axis direction is an X-axis direction, that is, a length direction of the electronic device 100 is an X-axis. It can be understood that a coordinate system of the electronic device 100 may alternatively be flexibly set according to a specific requirement. For example, the X-axis direction is defined as a first direction, and the Y-axis direction is defined as a second direction. In another implementation, the first direction and the second direction may alternatively be flexibly set according to a requirement, provided that the first direction is different from the second direction. It can be understood that, in this implementation, when the direction of the rotation axis of the electronic device 100 is the Y-axis direction, the electronic device 100 may be unfolded or folded along the Y-axis direction. In this way, when the electronic device 100 is in a closed state, a size of the electronic device 100 along the X-axis direction is reduced.

FIG. 26 is a partial exploded view of the electronic device 100 shown in FIG. 25 according to an implementation.

As shown in FIG. 25 and FIG. 26, the electronic device 100 includes a charging coil module 1, a display 2, a first housing 37, a second housing 38, a folding mechanism 39, and a load 4. The first housing 37, the second housing 38, and the folding mechanism 39 may constitute a housing apparatus of the electronic device 100.

In addition, the folding mechanism 39 is connected to the first housing 37 and the second housing 38. The folding mechanism 39 is configured to enable the first housing 37 and the second housing 38 to be unfolded or folded relative to each other. It can be understood that, in this application, the folding mechanism 39 may be an inward folding mechanism or an outward folding mechanism. The inward folding mechanism is a folding mechanism that enables at least a part of the display 2 to be folded between the two housings. The outward folding mechanism is a folding mechanism that enables at least a part of the display 2 to be folded out of the housings. A specific structure of the folding mechanism 39 is not limited in this application. In this implementation, an example in which the folding mechanism 39 is an inward folding mechanism is used for description.

As shown in FIG. 25 and FIG. 26, when the first housing 37, the second housing 38, and the folding mechanism 39 are unfolded relative to each other to an unfolded state, the electronic device 100 is in an unfolded state. For example, when the electronic device 100 is in the unfolded state, the first housing 37, the second housing 38, and the folding mechanism 39 may be arranged along the X-axis direction at approximately 180° (a slight deviation is allowed, for example, 165°, 177°, or 185° is possible).

As shown in FIG. 25 and FIG. 26, when the first housing 37, the second housing 38, and the folding mechanism 39 are folded relative to each other to a folded state, the electronic device 100 is in a folded state. For example, when the electronic device 100 is in the folded state, the first housing 37 and the second housing 38 may be close to each other, and the first housing 37 and the second housing 38 are stacked along the thickness direction of the electronic device 100 (that is, the Z-axis direction). When the first housing 37 and the second housing 38 switch from the unfolded state to the folded state, the folding mechanism 39 may enclose an accommodation space 331. It can be understood that folding mechanisms 39 of different structures have accommodation spaces 331 of different shapes.

As shown in FIG. 25 and FIG. 26, the display 2 may be a flexible display. For example, the display 2 may be an organic light-emitting diode (organic light-emitting diode, OLED) display panel, an active-matrix organic light-emitting diode (active-matrix organic light-emitting diode, AMOLED) display panel, a mini light-emitting diode (mini organic light-emitting diode) display panel, a micro organic light-emitting diode (micro organic light-emitting diode) display panel, or a quantum dot light-emitting diode (quantum dot light-emitting diode, QLED) display panel.

As shown in FIG. 25 and FIG. 26, the display 2 includes a first screen region 21, a second screen region 22, and a third screen region 23 that are sequentially connected. The second screen region 22 is connected between the first screen region 21 and the third screen region 23. For example, in FIG. 25 and FIG. 26, an example in which the first screen region 21, the second screen region 22, and the third screen region 23 are arranged along the X-axis direction is used for illustration, and the first screen region 21, the second screen region 22, and the third screen region 23 are distinguished by using dash-dot lines.

The first screen region 21 of the display 2 may be fastened to the first housing 37. The third screen region 23 may be fastened to the second housing 38. It can be understood that, when the folding mechanism 39 enables the first housing 37 and the second housing 38 to be unfolded or folded relative to each other, the first housing 37 may drive the first screen region 21 of the display 2 to be unfolded or folded relative to the third screen region 23, and the second housing 38 may drive the third screen region 23 of the display 2 to be unfolded or folded relative to the first screen region 21. In this case, the second screen region 22 of the display 2 may be bent.

In an implementation, the first screen region 21 of the display 2 may be fastened to the first housing 37 through a first adhesive layer (not shown in the figure), and the third screen region 23 may be fastened to the second housing 38 through a second adhesive layer (not shown in the figure). It can be understood that shapes, positions, and sizes of the first adhesive layer and the second adhesive layer are not specifically limited.

As shown in FIG. 25 and FIG. 26, when the electronic device 100 is in the unfolded state, the display 2 may be in an unfolded state. For example, the first screen region 21, the second screen region 22, and the third screen region 23 of the display 2 may be arranged at approximately 180° (a slight deviation is allowed, for example, 165°, 177°, or 185° is possible). In this case, the display 2 has a continuous large-area display region, in other words, the display 2 can implement large-screen display, so that user experience is good.

For example, when the electronic device 100 is in the unfolded state, at least a part of the folding mechanism 39 may be configured to support the second screen region 22. In this way, when the second screen region 22 of the display 2 is subject to a pressing force, an extrusion force, an impact force, or the like, the folding mechanism 39 may be configured to improve a pressure resistance capability and an impact resistance capability of the second screen region 22, to ensure that the second screen region 22 is not likely to be dented.

As shown in FIG. 25 and FIG. 26, when the electronic device 100 is in the folded state, the display 2 may be in a folded state. For example, the first screen region 21 and the third screen region 23 of the display 2 are arranged close to each other. In this case, the first screen region 21 and the third screen region 23 of the display 2 may be arranged along the Z-axis direction. In addition, the second screen region 22 of the display 2 is bent.

For example, when the electronic device 100 is in the folded state, all of the first screen region 21, the second screen region 22, and the third screen region 23 of the display 2 are located between the first housing 37 and the second housing 38, and the second screen region 22 is located in the accommodation space of the folding mechanism 39. When the electronic device 100 is in the folded state, because all of the first screen region 21, the second screen region 22, and the third screen region 23 of the display 2 are located between the first housing 37 and the second housing 38, a display surface of the first screen region 21 faces a display surface of the third screen region 23, the second screen region 22 is bent between the first screen region 21 and the third screen region 23, and the second screen region 22 is located in the accommodation space of the folding mechanism 39. The first screen region 21, the second screen region 22, and the third screen region 23 of the display 2 may be referred to as an inner screen of the display 2. When the first housing 37 and the second housing 38 are folded, the first screen region 21, the second screen region 22, and the third screen region 23 are folded into a space formed by the first housing 37, the second housing 38, and the folding mechanism 39. Therefore, the first screen region 21, the second screen region 22, and the third screen region 23 may also be referred to as an inner screen of the display 2.

As shown in FIG. 25 and FIG. 26, when the display 2 is mounted to the first housing 37 and the second housing 38, the display 2, the first housing 37, the second housing 38, and the folding mechanism 39 enclose an internal space of the electronic device 100. Both the charging coil module 1 and the load 4 may be located in the internal space of the electronic device 100. The charging coil module 1 is electrically connected to the load 4. When the electronic device 100 is in a charging state, the charging coil module 1 may charge the load 4. The load 4 may be a battery, a chip, a speaker, a camera, or another to-be-charged component. In FIG. 25 and FIG. 26, an example in which the load 4 is a battery is used for illustration.

It can be understood that, because both the charging coil module 1 and the load 4 may be located in the internal space of the electronic device 100, FIG. 25 shows the charging coil module 1 and the load 4 by using dashed lines.

FIG. 27 is a diagram of a structure of the charging coil module 1 shown in FIG. 25 according to an implementation.

As shown in FIG. 27, the charging coil module 1 includes a charging coil 10 and a circuit board 20. The charging coil 10 and the circuit board 20 may be of an integral structure. For a structure of the charging coil 10, refer to the structure of the charging coil 10 in the first implementation. Details are not described herein again.

As shown in FIG. 27, along an X-axis direction, the circuit board 20 includes a first part 201, a second part 202, and a third part 203 that are sequentially connected. In other words, the second part 202 is connected between the first part 201 and the third part 203. The second part 202 can be bent. It can be understood that, in FIG. 27, the first part 201, the second part 202, and the third part 203 are distinguished by using dashed lines.

In addition, the second part 202 of the circuit board 20 includes a first side surface 204 and a second side surface 205 that are arranged facing away from each other. The circuit board 20 is provided with a through hole 206. The through hole 206 forms an opening on the first side surface 204 and the second side surface 205.

Refer to FIG. 27, in combination with FIG. 25 and FIG. 26. The first part 201 of the circuit board 20 may be disposed on the first housing 37, and the third part 203 may be disposed on the second housing 38. In addition, the folding mechanism 39 passes through the through hole 206 of the circuit board 20. In other words, a part of the folding mechanism 39 is located on a side on which the first side surface 204 of the second part 202 is located, a part of the folding mechanism 39 is located in the through hole 206 of the second part 202, and a part of the folding mechanism 39 is located on a side on which the second side surface 205 of the second part 202 is located.

For example, along the X-axis direction, a width of the through hole 206 is greater than a width of the folding mechanism 39. In this way, the folding mechanism 39 can easily pass through the through hole 206.

It can be understood that the first part 201 of the circuit board 20 is disposed on the first housing 37, and the third part 203 is disposed on the second housing 38, so that the circuit board 20 can be configured to provide a power supply path for a load on the first housing 37 and the second housing 38, and the circuit board 20 can also be configured to provide a signal transmission path for an electronic component on the first housing 37 and the second housing 38.

It can be understood that, when the folding mechanism 39 enables the first housing 37 and the second housing 38 to be unfolded or folded relative to each other, the first housing 37 may drive the first part 201 of the circuit board 20 to be unfolded or folded relative to the third part 203, and the second housing 38 may drive the third part 203 of the circuit board 20 to be unfolded or folded relative to the first part 201. In this case, the second part 202 of the circuit board 20 can be bent. In an implementation, the first part 201 of the circuit board 20 may be fastened to the first housing 37, and the third part 203 of the circuit board 20 may be fastened to the second housing 38.

Refer to FIG. 27, in combination with FIG. 25 and FIG. 26. When the electronic device 100 is in the unfolded state, the circuit board 20 may be in an unfolded state. For example, the first part 201, the second part 202, and the third part 203 of the circuit board 20 may be arranged at approximately 180° (a slight deviation is allowed, for example, 165°, 177°, or 185° is possible). The circuit board 20 may be plate-shaped.

Refer to FIG. 27, in combination with FIG. 25 and FIG. 26. When the electronic device 100 is in the folded state, the circuit board 20 may be in a folded state. For example, the first part 201 and the third part 203 of the circuit board 20 may be arranged close to each other, and the second part 202 is bent. The circuit board 20 may be approximately "U"-shaped.

Refer to FIG. 27, in combination with FIG. 25 and FIG. 26. The charging coil 10 may be located in the first part 201 or the third part 203. It can be understood that, when the folding mechanism 39 enables the first housing 37 and the second housing 38 to be unfolded or folded relative to each other, the first part 201 and the third part 203 of the circuit board 20 are not bent. In this way, the charging coil may be located in the first part 201 or the third part 203, so that the charging coil 10 may not be bent when the first housing 37 and the second housing 38 are unfolded or folded relative to each other. This avoids damage to the charging coil 10, in other words, improves reliability of the charging coil 10. In another implementation, the charging coil 10 may alternatively be located in the second part 202 of the circuit board 20.

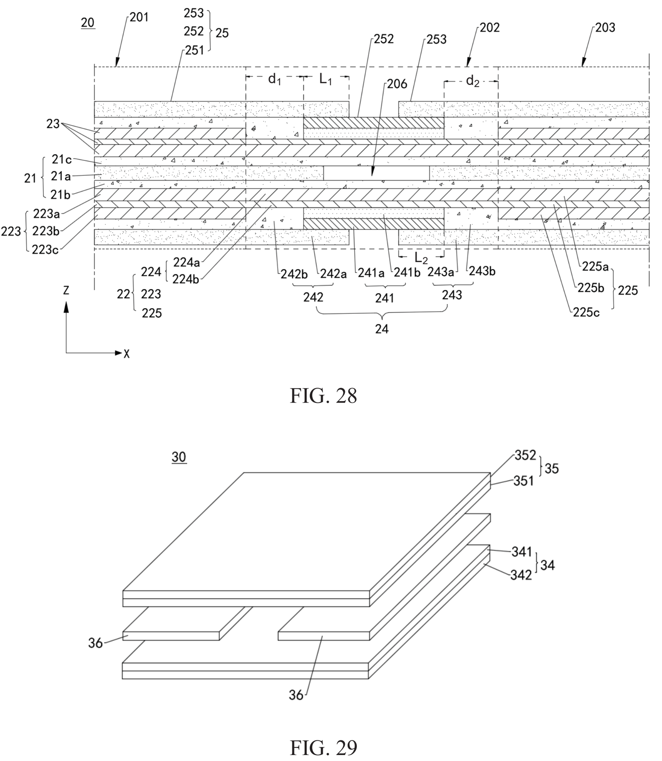

FIG. 28 is a partial cross-sectional view of the charging coil module 1 shown in FIG. 27 at a line G-G according to an implementation.

As shown in FIG. 28, along a Z-axis direction, the circuit board 20 includes a substrate 21, a first wiring layer 22, a second wiring layer 23, a first insulation layer 24, and a second insulation layer 25. It can be understood that the circuit board 20 may alternatively include more or fewer structures. For example, the circuit board 20 may include more structures. The circuit board 20 may further include a plurality of insulation layers and a plurality of wiring layers. The plurality of wiring layers and the plurality of insulation layers may be alternately stacked on the first insulation layer 24 and/or the second insulation layer 25. For another example, the circuit board 20 may include fewer structures. The circuit board 20 may alternatively not include the first insulation layer 24 and/or the second insulation layer 25 of the circuit board 20.

In an implementation, a material of the substrate 21 of the circuit board 20 may be an insulation material. For example, the substrate 21 of the circuit board 20 includes a three-layer structure, and specifically includes a first PI layer 21b, a bonding layer 21a, and a second PI layer 21c that are sequentially stacked. The bonding layer 21a is made of a polymer insulation bonding sheet (bonding sheet).

In an implementation, both a material of the first wiring layer 22 and a material of the second wiring layer 23 may be metal. For example, both the material of the first wiring layer 22 and the material of the second wiring layer 23 may be copper.

In an implementation, the first insulation layer 24 and the second insulation layer 25 of the circuit board 20 may be made of an insulation material. For example, both the first insulation layer 24 and the second insulation layer 25 of the circuit board 20 are of a two-layer structure, and specifically include a PI layer and an adhesive layer.

As shown in FIG. 28, the substrate 21 of the circuit board 20 may include a first surface 211 and a second surface 212 that are arranged facing away from each other. The first surface 211 of the substrate 21 of the circuit board 20 is a surface, away from the bonding layer 21a, of the first PI layer 21b. The second surface 212 of the substrate 21 of the circuit board 20 is a surface, away from the bonding layer 21a, of the second PI layer 21c. The first wiring layer 22 may be disposed on the first surface 211 of the substrate 21 of the circuit board 20. The second wiring layer 23 may be disposed on the second surface 212 of the substrate 21 of the circuit board 20. In other words, the substrate 21 of the circuit board 20 is located between the first wiring layer 22 and the second wiring layer 23.

As shown in FIG. 28, the through hole 206 of the circuit board 20 is located on the substrate 21 of the circuit board 20, and the through hole 206 of the circuit board 20 forms an opening on two side surfaces of the substrate 21 of the circuit board 20. In this way, when the folding mechanism 39 passes through the through hole 206 of the circuit board 20, the folding mechanism 39 is not likely to affect the first wiring layer 22 or the second wiring layer 23 of the circuit board 20. For example, when the substrate 21 of the circuit board 20 includes the first PI layer 21b, the bonding layer 21a, and the second PI layer 21c that are sequentially stacked, the through hole 206 of the circuit board 20 is provided on the bonding layer 21a of the substrate 21 of the circuit board 20.

It can be understood that, along an X-axis direction, the circuit board 20 is divided into three parts: the first part 201, the second part 202, and the third part 203. Along the X-axis direction, the first wiring layer 22 is also correspondingly divided into three parts: a first wiring layer 223 of the first part 201, a first wiring layer 224 of the second part 202, and a first wiring layer 225 of the third part 203. It can be understood that, in FIG. 28, the first part 201, the second part 202, and the third part 203 are distinguished by using dashed-line boxes with different linear scales.

In this implementation, along the Z-axis direction, a thickness of the first wiring layer 224 of the second part 202 is less than a thickness of the first wiring layer 223 of the first part 201 and a thickness of the first wiring layer 225 of the third part 203. The first wiring layer 223 of the first part 201 and the first wiring layer 225 of the third part 203 are disposed in a same manner or similar manners. The first wiring layer 223 of the first part 201 is used below as an example for description.

In an implementation, along the Z-axis direction, the thickness of the first wiring layer 223 of the first part 201 ranges from 5 micrometers to 100 micrometers. For example, the thickness of the first wiring layer 223 of the first part 201 is equal to 85 micrometers.

In an implementation, along the Z-axis direction, the thickness of the first wiring layer 224 of the second part 202 ranges from 10 micrometers to 80 micrometers. For example, the thickness of the first wiring layer 223 of the first part 201 is equal to 40 micrometers.

In an implementation, along the Z-axis direction, the thickness of the first wiring layer 225 of the third part 203 ranges from 5 micrometers to 100 micrometers. For example, the thickness of the first wiring layer 225 of the third part 203 is equal to 85 micrometers.

For example, the first wiring layer 223 of the first part 201 includes three metal layers, and a second wire of the second part 202 includes two metal layers. A first layer of metal 223a of the first wiring layer 223 of the first part 201, a first layer of metal 224a of the first wiring layer 224 of the second part 202, and a first layer of metal 225a of the first wiring layer 225 of the third part 203 are disposed at a same layer, and are of an integrally formed structure. In addition, a second layer of metal 223b of the first wiring layer 223 of the first part 201, a second layer of metal 224b of the first wiring layer 224 of the second part 202, and a second layer of metal 225b of the first wiring layer 225 of the third part 203 are also disposed at a same layer, and are of an integrally formed structure. A third layer of metal 223c of the first wiring layer 223 of the first part 201 and a third layer of metal 225c of the first wiring layer 225 of the third part 203 are disposed at a same layer at a spacing. In other words, the third layer of metal 223c of the first wiring layer 223 of the first part 201 and the third layer of metal 225c of the first wiring layer 225 of the third part 203 may be formed through a same process. It can be understood that both the third layer of metal 223c of the first wiring layer 223 of the first part 201 and the third layer of metal 225c of the first wiring layer 225 of the third part 203 protrude from the second layer of metal 224b of the first wiring layer 224 of the second part 202.

For example, the second layer of metal 223b of the first wiring layer 223 of the first part 201, the second layer of metal 224b of the first wiring layer 224 of the second part 202, and the second layer of metal 225b of the first wiring layer 225 of the third part 203 may be formed on the first layer of metal 223a of the first wiring layer 223 of the first part 201, the first layer of metal 224a of the first wiring layer 224 of the second part 202, and the first layer of metal 225a of the first wiring layer 225 of the third part 203 respectively through an electroplating process. The third layer of metal 223c of the first wiring layer 223 of the first part 201 may be formed on the second layer of metal 223b of the first wiring layer 223 of the first part 201 through an electroplating process. The third layer of metal 225c of the first wiring layer 225 of the third part 203 may be formed on the second layer of metal 225b of the first wiring layer 225 of the third part 203 through an electroplating process.

As shown in FIG. 28, the first insulation layer 24 of the circuit board 20 may be disposed on the first wiring layer 22 and cover the first wiring layer 22. The first insulation layer 24 of the circuit board 20 may be configured to protect the first wiring layer 22.

In this implementation, the first insulation layer 24 includes a first insulation sublayer 241, a second insulation sublayer 242, and a third insulation sublayer 243. Glass transition temperature (glass transition temperature, Tg) of the first insulation sublayer 241 is greater than glass transition temperature of the second insulation sublayer 242 and glass transition temperature of the third insulation sublayer 243. In this way, the first insulation sublayer 241 is not likely to undergo glass transition due to high-temperature processing in a subsequent process of the circuit board 20, to avoid an offset of a bending stress center line of the second part 202 of the circuit board 20, and avoid a failure of the first insulation sublayer 241 to protect the first wiring layer 224 of the second part 202. In addition, the first insulation sublayer 241 is not likely to undergo glass transition during folding or unfolding of the circuit board 20, to avoid an offset of the bending stress center line of the second part 202 of the circuit board 20, and avoid a failure of the first insulation sublayer 241 to protect the first wiring layer 224 of the second part 202.

For example, the glass transition temperature of the first insulation sublayer 241 is greater than or equal to 90°C. For example, the glass transition temperature of the first insulation sublayer 241 ranges from 90°C to 150°C.

For example, the glass transition temperature of the second insulation sublayer 242 is less than 90°C. For example, the glass transition temperature of the second insulation sublayer 242 ranges from 60°C to 70°C.

For example, the glass transition temperature of the third insulation sublayer 243 is less than 90°C. For example, the glass transition temperature of the third insulation sublayer 243 ranges from 60°C to 70°C.

In this implementation, the first insulation sublayer 241 is disposed on the first wiring layer 224 of the second part 202, and covers a part of the first wiring layer 224 of the second part 202. The first insulation sublayer 241 is spaced away from the third layer of metal 223c of the first wiring layer 223 of the first part 201. The first insulation sublayer 241 is also spaced away from the third layer of metal 225c of the first wiring layer 225 of the third part 203. This can ensure that, during bending of the second part 202 of the circuit board 20, a wire at the first wiring layer 22 and/or a wire at the second wiring layer 23 are/is not likely to break due to concentrated stress.

For example, along the X-axis direction, a distance d₁ between the first insulation sublayer 241 and the third layer of metal 223c of the first wiring layer 223 of the first part 201 satisfies d₁ ≥ 0 millimeters. For example, 0.2 millimeter ≤ d₁ ≤ 0.5 millimeter.

For example, along the X-axis direction, a distance d₂ between the first insulation sublayer 241 and the third layer of metal 225c of the first wiring layer 225 of the third part 203 satisfies d₂ ≥ 0 millimeters. For example, 0.2 millimeter ≤ d₂ ≤ 0.5 millimeter.

In this implementation, a part of the second insulation sublayer 242 is disposed on the first wiring layer 223 of the first part 201, and a part of the second insulation sublayer 242 is disposed on the first insulation sublayer 241, in other words, a part of the second insulation sublayer 242 overlaps the first insulation sublayer 241. In this case, the second insulation sublayer 242 may cover the first wiring layer 223 of the first part 201, a space between the first wiring layer 223 of the first part 201 and the first insulation sublayer 241, and a part of the first insulation sublayer 241. In this way, during bending of the second part 202 of the circuit board 20, the first insulation sublayer 241 and the second insulation sublayer 242 can keep covering the first part 201 and the first wiring layer 224 of the second part 202.

In an implementation, along the X-axis direction, a width L₁ of a part, disposed on the first insulation sublayer 241, of the second insulation sublayer 242 satisfies L₁ ≥ 0.05 millimeter. For example, 0.2 millimeter ≤ L₁ ≤ 0.5 millimeter.

In this implementation, a part of the third insulation sublayer 243 is disposed on the first wiring layer 225 of the third part 203, and a part of the third insulation sublayer 243 is disposed on the first insulation sublayer 241, in other words, a part of the third insulation sublayer 243 overlaps the first insulation sublayer 241. In this way, the third insulation sublayer 243 can cover the first wiring layer 225 of the third part 203, a space between the first wiring layer 225 of the third part 203 and the first insulation sublayer 241, and a part of the first insulation sublayer 241. In this way, during bending of the second part 202 of the circuit board 20, the first insulation sublayer 241 and the second insulation sublayer 242 can keep covering the third part 203 and the first wiring layer 224 of the second part 202.

In an implementation, along the X-axis direction, a width L₂ of a part, disposed on the first insulation sublayer 241, of the third insulation sublayer 243 satisfies L₂ ≥ 0.2 millimeter. For example, 0.2 millimeter ≤ L₂ ≤ 0.5 millimeter.

In an implementation, along the Z-axis direction, the first insulation sublayer 241 includes a first PI layer 241a (namely, a first polyimide layer) and a first AD layer 241b (a first adhesive layer), where the first AD layer 241b is bonded to the first wiring layer 224 of the second part 202. In addition, along the Z-axis direction, the second insulation sublayer 242 includes a second PI layer 242a and a second AD layer 242b, where the second AD layer 242b is bonded to the first wiring layer 223 of the first part 201. In addition, the third insulation sublayer 243 includes a third PI layer 243a and a third AD layer 243b, where the third AD layer 243b is bonded to the first wiring layer 225 of the third part 203.

In this implementation, along the Z-axis direction, a thickness of the second AD layer 242b and a thickness of the third AD layer 243b are greater than a thickness of the first AD layer 241b. In this way, the thick second AD layer 242b can well cover the first wiring layer 223 of the first part 201, and two adjacent wires at the first wiring layer 223 of the first part 201 can be well spaced apart by the second AD layer 242b. In addition, the thick third AD layer 243b can well cover the first wiring layer 225 of the third part 201, and two adjacent wires at the first wiring layer 223 of the third part 201 can be well spaced apart by the third AD layer 243b. In addition, because the first wiring layer 224 of the second part 202 is thin, the thin first AD layer 241b can well cover the first wiring layer 224 of the second part 202, and two adjacent wires at the first wiring layer 224 of the second part 202 can be well spaced apart by the first AD layer 241b.

For example, along the Z-axis direction, a ratio of the thickness of the first AD layer 241b to the thickness of the first wiring layer 224 of the second part 202 ranges from 0.6 to 0.9. For example, along the Z-axis direction, the ratio of the thickness of the first AD layer 241b to the thickness of the first wiring layer 224 of the second part 202 may be 0.6, 0.7, 0.8, or 0.9. This can ensure that the first AD layer 241b can well cover the first wiring layer 224 of the second part 202.

For example, along the Z-axis direction, a ratio of the thickness of the second AD layer 242b to the thickness of the first wiring layer 223 of the first part 201 ranges from 0.6 to 0.9. For example, along the Z-axis direction, the ratio of the thickness of the second AD layer 242b to the thickness of the first wiring layer 223 of the first part 201 may be 0.6, 0.7, 0.8, or 0.9. This can ensure that the second AD layer 242b can well cover the first wiring layer 223 of the first part 201.

It can be understood that, for the thickness of the third AD layer 243b, reference may be made to the manner of setting the thickness of the second AD layer 242b. Details are not described herein again.

For example, along the Z-axis direction, the thickness of the first AD layer 241b is less than 25 micrometers. For example, the thickness of the first AD layer 241b is 12 micrometers.

For example, along the Z-axis direction, the thickness of the second AD layer 242b is greater than 25 micrometers. For example, the thickness of the first AD layer 241b is 32 micrometers.

For example, along the Z-axis direction, the thickness of the third AD layer 243b is greater than 25 micrometers. For example, the thickness of the third AD layer 243b is 32 micrometers.

In an implementation, along the Z-axis direction, the thickness of the first AD layer 241b ranges from 5 micrometers to 40 micrometers.

In an implementation, along the Z-axis direction, the thickness of the second AD layer 242b ranges from 5 micrometers to 40 micrometers.

In an implementation, along the Z-axis direction, the thickness of the third AD layer 243b ranges from 5 micrometers to 40 micrometers.

It can be understood that the second wiring layer 23 and the first wiring layer 22 may be of a same structure, similar structures, symmetric or partially symmetric structures, or different structures. In this implementation, the second wiring layer 23 and the first wiring layer 22 are of symmetric structures. For a basic design of a component structure of the second wiring layer 23, a design of a connection relationship between components, and a design of a connection relationship between a component and another structure other than a component, refer to a related solution of the first wiring layer 22. In addition, the second wiring layer 23 and the first wiring layer 22 are allowed to be slightly different in terms of a detailed structure or position arrangement of components.

In addition, the second insulation layer 25 and the first insulation layer 24 may be of a same structure, similar structures, symmetric or partially symmetric structures, or different structures. In this implementation, the second insulation layer 25 and the first insulation layer 24 are of symmetric structures. For a basic design of a component structure of the second insulation layer 25, a design of a connection relationship between components, and a design of a connection relationship between a component and another structure other than a component, refer to a related solution of the first insulation layer 24. In addition, the second insulation layer 25 and the first insulation layer 24 are allowed to be slightly different in terms of a detailed structure or position arrangement of components.

It can be understood that arrangement of the second wiring layer 23 and arrangement of the second insulation layer 25 are not described in detail herein.

In this implementation, the thickness of the first wiring layer 224 of the second part 202 is set to be less than the thickness of the first wiring layer 223 of the first part 201 and the thickness of the first wiring layer 225 of the third part 203, that is, the thickness of the first wiring layer 224 of the second part 202 is set to be small, to adjust the stress center line of the second part 202 of the circuit board 20, to make the stress center line of the second part 202 of the circuit board 20 fall on an insulation layer of the second part 202 of the circuit board 20, to be specific, prevent the stress center line of the second part 202 of the circuit board 20 from falling on the first wiring layer 224 of the second part 202. This ensures that the first insulation sublayer 241 can protect the first wiring layer 224 of the second part 202, to improve service life of the charging coil module 1.

In addition, the through hole 206 is provided on a substrate of the second part 202 of the circuit board 20. The through hole 206 may be configured to allow the folding mechanism 39 to pass through. In addition, the stress center line of the second part 202 of the circuit board 20 may be adjusted, to make the stress center line of the second part 202 of the circuit board 20 fall on an insulation layer of the second part 202 of the circuit board 20, to be specific, prevent the stress center line of the second part 202 of the circuit board 20 from falling on the first wiring layer 224 of the second part 202. This ensures that the first insulation sublayer 241 can protect the first wiring layer 224 of the second part 202, to improve service life of the charging coil module 1.

It can be understood that the first insulation sublayer 241 is disposed on the first wiring layer 224 of the second part 202, the second insulation sublayer 242 is disposed on the first wiring layer 223 of the first part 201, the third insulation sublayer 243 is disposed on the first wiring layer 225 of the third part 203, and the glass transition temperature of the first insulation sublayer 241 is greater than the glass transition temperature of the second insulation sublayer 242 and the glass transition temperature of the third insulation sublayer 243. In this way, the first insulation sublayer 241 is not likely to undergo glass transition due to high-temperature processing in a subsequent process of the circuit board, to avoid an offset of the bending stress center line of the second part 202, and avoid a failure of the first insulation sublayer 241 to protect the first wiring layer 224 of the second part 202. In addition, the first insulation sublayer 241 is not likely to undergo glass transition during folding or unfolding of the circuit board 20, to avoid an offset of a bending stress center line of the first wiring layer 224 of the second part 202, and avoid a failure of the first insulation sublayer 241 to protect the first wiring layer 224 of the second part 202.

In addition, because the first part 201 and the third part 203 of the circuit board 20 may not be bent during folding or unfolding of the circuit board 20, a center line offset issue of the first part 201 and the third part 203 of the circuit board 20 may not need to be considered. In this implementation, both the glass transition temperature of the second insulation sublayer 242 and the glass transition temperature of the third insulation sublayer 243 are set to be low. In this way, the second insulation sublayer 242 and the third insulation sublayer 243 can be disposed on the first wiring layer 223 of the first part 201 and the first wiring layer 225 of the third part 203 respectively without high-temperature processing, to reduce difficulty in performing coverage by using the second insulation sublayer 242 and the third insulation sublayer 243.

It can be understood that both the thickness of the first wiring layer 223 of the first part 201 and the thickness of the first wiring layer 225 of the third part 203 are set to be greater than the thickness of the first wiring layer 224 of the second part 202. In this way, the thickness of the first wiring layer 224 of the second part 202 can be set to be small, to adjust the stress center line of the second part 202 of the circuit board 20, to make the stress center line of the second part 202 of the circuit board 20 fall on an insulation layer of the second part 202 of the circuit board 20, to be specific, prevent the stress center line of the second part 202 of the circuit board 20 from falling on the first wiring layer 224 of the second part 202. This ensures that the first insulation sublayer 241 can protect the first wiring layer 224 of the second part 202, to improve service life of the charging coil module 1.

It can be understood that a part of the second insulation sublayer 242 is arranged to overlap the first insulation sublayer 241, and the distance d₁ between the first insulation sublayer 241 and the third layer of metal of the first wiring layer of the first part is set to satisfy 0.2 millimeter ≤ d₁ ≤ 0.5 millimeter. This can ensure that the first wiring layer 224 of the second part 202 is likely to break due to excessively concentrated stress, to ensure that the charging coil module 1 has long service life.

It can be understood that the width L₁ of the part, disposed on the first insulation sublayer 241, of the second insulation sublayer 242 is set to satisfy L₁ ≥ 0.05 millimeter. In this way, during bending of the second part 202 of the circuit board 20, the first insulation sublayer 241 and the second insulation sublayer 242 are not likely to be separated at a joint, the first wiring layer 224 of the second part 202 can be covered by the first insulation sublayer 241 and the second insulation sublayer 242, and the first wiring layer 224 of the second part 202 is not likely to break, to ensure that the charging coil module 1 has long service life.

It can be understood that, when the charging coil module 1 achieves higher wireless charging efficiency through a reduction in a link loss, the first coil 12 and the second coil 13 in the charging coil 10 can be arranged at a narrow spacing. When sizes are the same, compared with a charging coil 10 in which narrow-spacing arrangement is not implemented, the charging coil 10 in this implementation contains more metal (for example, copper) per unit area, so that a charging loss is effectively reduced. This helps extend duration in which the charging coil 10 remains at a peak value of 50 W during charging, and improves charging efficiency.

It can be understood that, when the charging coil module 1 achieves higher wireless charging efficiency through a reduction in a link loss, the first coil 12 and the second coil 13 in the charging coil 10 can be arranged at a narrow spacing, a large thickness (for example, the thickness is greater than 40 micrometers), and a large wire width (for example, the wire width is greater than 40 micrometers). This helps reduce impedance of a charging path. For example, compared with charging impedance (for example, 45.2 ohms) of a conventional charging coil module, charging impedance of the charging coil module 1 in this implementation can be reduced to 25.6 ohms, with a reduction of approximately 43%. In addition, a heat dissipation capability of the charging coil module 1 can also be improved.

The foregoing specifically describes a specific structure of the charging coil module 1 in this application. The following specifically describes a preparation process for the charging coil module 1 with reference to the accompanying drawings. This implementation is approximately the same as the preparation method for the charging coil module 1 in the foregoing implementation (FIG. 12 to FIG. 24), and same technical content is not described herein again.

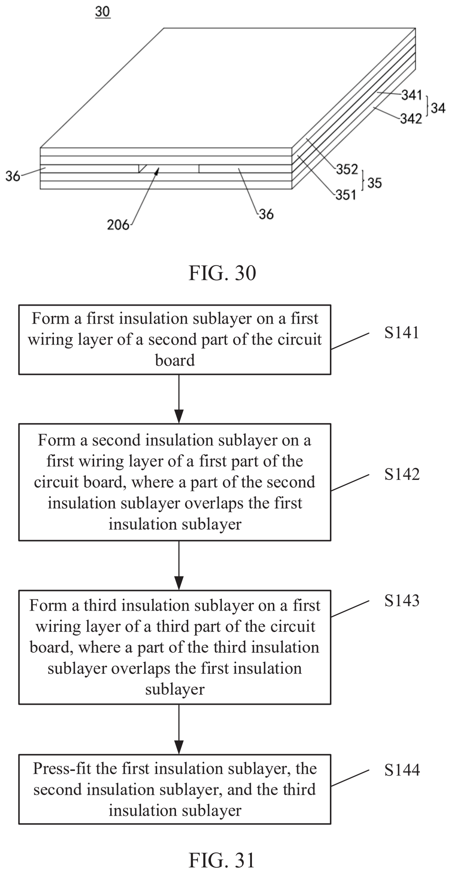

A double-sided board 30 is prepared. Technical content of this step that is the same as that of step S110 in the foregoing implementation is not described again. A difference lies in that FIG. 29 and FIG. 30 are diagrams 1 and 2 of structures of some steps of the preparation method for the charging coil module 1 shown in FIG. 12 according to some other embodiments. As shown in FIG. 29 and FIG. 30, two bonding sheets 36 are used in this implementation. The two bonding sheets 36 are located between a first flexible copper clad laminate 34 and a second flexible copper clad laminate 35 at a spacing. In this way, after the first flexible copper clad laminate 34, the two bonding sheets 36, and the second flexible copper clad laminate 35 are press-fit to form the double-sided board 30, the first flexible copper clad laminate 34, the second flexible copper clad laminate 35, and the two bonding sheets 36 enclose a through hole 206 of a circuit board 20.

A first etching layer 32 of the double-sided board 30 is processed to form a first coil 12 of a charging coil 10 and a first wiring layer 22 of the circuit board 20. It can be understood that technical content of this step that is the same as that of step S120 in the foregoing implementation is not described again. For details, refer to the preparation method shown in FIG. 16 to FIG. 20. Details are not described herein again.

A difference from step S120 lies in: It can be understood that, in step S120, after the film application process, the exposure process, the development process, the etching process, the film removal process, and the like are performed on the first etching layer 32 of the double-sided board 30, electroplating may be further performed on the first conducting portion 1222 of the first coil 12 of the charging coil 10 through an electroplating process to form the second conducting portion 1223 of the first coil 12. However, in this implementation, electroplating may be further performed on a first conducting portion of a first wiring layer 22 of a first part 201 and a first conducting portion of a first wiring layer 22 of a third part 203 through an electroplating process to form second conducting portions, to greatly increase a thickness of the first wiring layer 22 of the first part 201 and a thickness of the first wiring layer 22 of the third part 203. However, a first wiring layer 22 of a second part 202 of the circuit board 20 is not electroplated through an electroplating process. For example, during the electroplating process, the first wiring layer 22 of the second part 202 of the circuit board 20 is covered by a dry film, and the first wiring layer 22 of the first part 201 and the first wiring layer 22 of the third part 203 are electroplated.

It can be understood that the first wiring layer 22 of the first part 201 and the first wiring layer 22 of the third part 203 contain more metal (for example, copper) per unit area, and a size of a wire at the first wiring layer 22 of the circuit board 20 can be larger, to reduce a charging loss. In addition, when a wire with a same function is implemented, a quantity of stacked layers of the circuit board 20 can be reduced.

A second etching layer 33 of the double-sided board 30 is processed to form a second coil 13 of the charging coil 10 and a second wiring layer 23 of the circuit board 20. It can be understood that this step is the same as or similar to processing the first etching layer 32 of the double-sided board 30. Details are not described herein again.

A first covering layer 41 is formed on the first coil 12 of the charging coil 10 and the first wiring layer 22 of the circuit board 20, and a second covering layer 42 is formed on the second coil 13 of the charging coil 10 and the second wiring layer 23 of the circuit board 20. The first covering layer 41 covers the first coil 12 of the charging coil 10 and the first wiring layer 22 of the circuit board 20. The second covering layer 42 covers the second coil 13 of the charging coil 10 and the second wiring layer 23 of the circuit board 20.

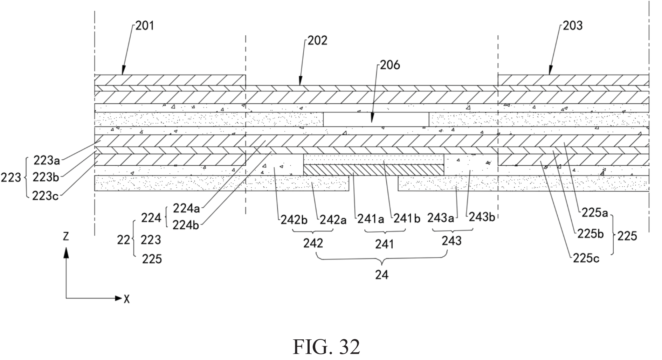

It can be understood that a forming manner and a structure of the first covering layer 41 are similar to or the same as a forming manner and a structure of the second covering layer 42. The forming manner and the structure of the first covering layer 41 are used below as an example for description. FIG. 31 is a flowchart of preparing the charging coil module 1 shown in FIG. 28 according to an implementation. FIG. 32 is a diagram 1 of a structure of some steps of the preparation method for the charging coil module 1 shown in FIG. 31 according to some embodiments.

Refer to FIG. 31 and FIG. 32. In an implementation, the step of forming the first covering layer 41 on the first coil 12 of the charging coil 10 and the first wiring layer 22 of the circuit board 20 includes the following sub-steps.

S141: Form a first insulation sublayer 241 on a first wiring layer 224 of the second part 202 of the circuit board 20. The first insulation sublayer 241 covers at least a part of the first wiring layer 224 of the second part 202 of the circuit board 20. It can be understood that, for arrangement of the first insulation sublayer 241, reference may be made to the foregoing arrangement of the first insulation sublayer 241 of the charging coil module 1 in the foregoing descriptions. Details are not described herein again.

S142: Form a second insulation sublayer 242 on a first wiring layer 223 of the first part 201 of the circuit board 20, where a part of the second insulation sublayer 242 overlaps the first insulation sublayer 241. The second insulation sublayer 242 may cover the first wiring layer 223 of the first part 201, a space between the first wiring layer 223 of the first part 201 and the first insulation sublayer 241, and a part of the first insulation sublayer 241.

It can be understood that, for arrangement of the second insulation sublayer 242, reference may be made to the foregoing arrangement of the second insulation sublayer 242 of the charging coil module 1 in the foregoing descriptions. Details are not described herein again.

S143: Form a third insulation sublayer 243 on a first wiring layer 225 of the third part 203 of the circuit board 20, where a part of the third insulation sublayer 243 overlaps the first insulation sublayer 241. It can be understood that, for this step, reference may be made to step S242. Details are not described herein again.

S144: Press-fit the first insulation sublayer 241, the second insulation sublayer 242, and the third insulation sublayer 243.

In an implementation, a thermal compression bonding process is used. Thermal compression bonding temperature may range from 150°C to 200°C, and thermal compression bonding time may range from 0.5 hour (unit: h) to 3 hours (h).

In an implementation, a pressure transfer process is used. Pressure transfer temperature may range from 170°C to 190°C, and pressure transfer time may range from 0.5 hour (unit: h) to 3 hours (h). For example, the pressure transfer time may be 2 hours. Pressure may range from 350 N/cm² to 450 N/cm².

In an implementation, a rapid pressure bonding process is used. Rapid pressure bonding temperature may range from 170°C to 190°C, and rapid pressure bonding time may range from 1 minute (unit: min) to 8 minutes (unit: min). For example, the rapid pressure bonding time may range from 2 min to 3 min. In addition, pressure may range from 100 N/cm² to 150 N/cm². Baking temperature may range from 160°C to 180°C, and baking time may range from 1 hour (unit: h) to 3 hours (h). For example, the baking time may be 2 hours.

In another implementation, a vacuum press-fitting process may alternatively be used to press-fit the first insulation sublayer 241, the second insulation sublayer 242, and the third insulation sublayer 243. Details are not described herein again.

In an implementation, after the step of forming the first insulation sublayer 241 on the first wiring layer 224 of the second part 202 of the circuit board 20, the first insulation sublayer 241 is first press-fit through a first press-fitting process. After the step of forming the second insulation sublayer 242 on the first wiring layer 223 of the first part 201 of the circuit board 20, and forming the third insulation sublayer 243 on the first wiring layer 225 of the third part 203 of the circuit board 20, the second insulation sublayer 242 and the third insulation sublayer 243 are then press-fit through a second press-fitting process. For example, temperature of the two press-fitting processes may range from 175°C to 190°C, and thermal compression bonding time may range from 0.5 hour (unit: h) to 3 hours (h). It can be understood that two press-fitting processes are used in this implementation. However, in the foregoing descriptions of using one press-fitting process, a risk of delamination of the first insulation sublayer 241, the second insulation sublayer 242, and the third insulation sublayer 243 during two times of thermal compression bonding in mass production can be reduced. In addition, the first insulation sublayer 241, the second insulation sublayer 242, and the third insulation sublayer 243 can be prevented from undergoing glass transition at a plurality of times of high temperature, to avoid a center line offset and avoid a failure to protect the first wiring layer 22 during folding.

A first nanocrystalline layer 16 is formed on a first insulation layer 14 of the charging coil 10.

It can be understood that this step is the same as or similar to step S150 in the foregoing implementation. Details are not described herein again. A first graphite layer 17 is formed on the first nanocrystalline layer 16.

It can be understood that this step is the same as or similar to step S160 in the foregoing implementation. Details are not described herein again.

It can be understood that the charging coil 10 in this implementation may also include a second nanocrystalline layer and a second graphite layer. For manners of arranging and forming the second nanocrystalline layer and the second graphite layer, refer to the foregoing manners of arranging and forming the second nanocrystalline layer 18 and the second graphite layer 19. Details are not described herein again.

It should be noted that embodiments of this application or features in implementations may be combined with each other if there is no conflict, and any combination of features in different implementations also falls within the protection scope of this application. That is, the plurality of embodiments described above may alternatively be combined in any manner according to an actual requirement.

It should be noted that all of the foregoing accompanying drawings are example drawings of this application, and do not represent actual sizes of products. In addition, a size proportion relationship between components in the accompanying drawings is not intended to limit an actual product in this application.

The foregoing descriptions are merely some embodiments and implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A charging coil module (1), comprising a charging coil (10) and a circuit board (20), wherein
the charging coil (10) comprises a substrate (11), a first coil (12), and a second coil (13), and the substrate (11) of the charging coil (10) is located between the first coil (12) and the second coil (13);
the circuit board (20) comprises a substrate (21), a first wiring layer (22), and a second wiring layer (23), and the substrate (21) of the circuit board (20) is located between the first wiring layer (22) and the second wiring layer (23); and
the substrate (21) of the circuit board (20) and the substrate (11) of the charging coil (10) are of an integrated structure, the first wiring layer (22) and the first coil (12) are disposed at a same layer, and the second wiring layer (23) and the second coil (13) are disposed at a same layer.

2. The charging coil module (1) according to claim 1, wherein the first wiring layer (22) comprises a first wire (221), and the first wire (221) and the first coil (12) are of an integrally formed structure; and/or
the second wiring layer (23) comprises a second wire (231), and the second wire (231) and the second coil (13) are of an integrally formed structure.

3. The charging coil module (1) according to claim 1 or 2, wherein the charging coil (10) comprises a first insulation layer (14), and the first insulation layer (14) of the charging coil (10) is disposed on the first coil (12) and covers the first coil (12);
the circuit board (20) comprises a first insulation layer (24), and the first insulation layer (24) of the circuit board (20) is disposed on the first wiring layer (22) and covers the first wiring layer (22); and
the first insulation layer (14) of the charging coil (10) and the first insulation layer (24) of the circuit board (20) are disposed at a same layer, and are of an integrally formed structure.

4. The charging coil module (1) according to claim 1 or 2, wherein along a length direction of the circuit board (20), the circuit board (20) comprises a first part (201), a second part (202), and a third part (203) that are sequentially connected; and when the first part (201) and the third part (203) are folded or unfolded relative to each other, the second part (202) is bent;
the circuit board (20) comprises a first insulation sublayer (241), a second insulation sublayer (242), and a third insulation sublayer (243), the first insulation sublayer (241) is disposed on a first wiring layer (224) of the second part (202), the second insulation sublayer (242) is disposed on a first wiring layer (223) of the first part (201), and the third insulation sublayer (243) is disposed on a first wiring layer (225) of the third part (203); and
glass transition temperature of the first insulation sublayer (241) is greater than glass transition temperature of the second insulation sublayer (242) and glass transition temperature of the third insulation sublayer (243).

5. The charging coil module (1) according to claim 4, wherein the charging coil (10) comprises a first insulation layer (14), and the first insulation layer (14) of the charging coil (10) is disposed on the first coil (12) and covers the first coil (12); and
the first insulation layer (14) of the charging coil (10) and the second insulation sublayer (242) are of an integrally formed structure, or the first insulation layer (14) of the charging coil (10) and the third insulation sublayer (243) are of an integrally formed structure.

6. The charging coil module (1) according to claim 4 or 5, wherein the glass transition temperature of the first insulation sublayer (241) is greater than or equal to 90°C, and both the glass transition temperature of the second insulation sublayer (242) and the glass transition temperature of the third insulation sublayer (243) are less than 90°C.

7. The charging coil module (1) according to any one of claims 4 to 6, wherein a thickness of a first adhesive layer (241b) of the first insulation sublayer (241) is less than a thickness of a second adhesive layer (242b) of the second insulation sublayer (242) and a thickness of a third adhesive layer (243b) of the third insulation sublayer (243).

8. The charging coil module (1) according to claim 7, wherein the thickness of the first adhesive layer (241b) of the first insulation sublayer (241) is less than 25 micrometers, and the thickness of the second adhesive layer (242b) of the second insulation sublayer (242) and the thickness of the third adhesive layer (243b) of the third insulation sublayer (243) are greater than 25 micrometers.

9. The charging coil module (1) according to any one of claims 5 to 8, wherein a thickness of the first wiring layer (224) of the second part (202) is less than a thickness of the first wiring layer (223) of the first part (201) and a thickness of the first wiring layer (225) of the third part (203).

10. The charging coil module (1) according to claim 9, wherein the first wiring layer (223) of the first part (201) comprises three metal layers, and a second wire of the second part (202) comprises two metal layers;
a first layer of metal (223a) of the first wiring layer (223) of the first part (201) and a first layer of metal (224a) of the first wiring layer (224) of the second part (202) are disposed at a same layer, and are of an integrally formed structure; and
a second layer of metal (223b) of the first wiring layer (223) of the first part (201) and a second layer of metal (224b) of the first wiring layer (224) of the second part (202) are disposed at a same layer, and are of an integrally formed structure.

11. The charging coil module (1) according to claim 9, wherein a distance d₁ between the first insulation sublayer (241) and a third layer of metal (223c) of the first wiring layer (223) of the first part (201) satisfies 0.2 millimeter ≤ d₁ ≤ 0.5 millimeter.

12. The charging coil module (1) according to any one of claims 9 to 11, wherein a part of the second insulation sublayer (242) overlaps the first insulation sublayer (241); and
a width L₁ of a part, disposed on the first insulation sublayer (241), of the second insulation sublayer (242) satisfies L₁ ≥ 0.05 millimeter.

13. The charging coil module (1) according to any one of claims 4 to 12, wherein the charging coil (10) comprises a first nanocrystalline layer (16) and a first graphite layer (17), and the first nanocrystalline layer (16) and the first graphite layer (17) are sequentially stacked on the first insulation layer (14) of the charging coil (10).

14. The charging coil module (1) according to any one of claims 1 to 13, wherein a quantity of turns of the first coil (12) is greater than or equal to 2, and a distance between two adjacent turns of the first coil (12) ranges from 40 micrometers to 100 micrometers.

15. The charging coil module (1) according to any one of claims 1 to 14, wherein each turn of the first coil (12) comprises a first conducting portion (1222) and a second conducting portion (1223), the first conducting portion (1222) is disposed on the substrate (11) of the charging coil (10), and the second conducting portion (1223) is formed on the first conducting portion (1222) through electroplating.

16. An electronic device (100), comprising a load (4) and the charging coil module (1) according to any one of claims 1 to 15, wherein the charging coil module (1) is electrically connected to the load (4).

17. A charger (200), comprising the charging coil module (1) according to any one of claims 1 to 15.

18. A charging system (1000), comprising an electronic device (100) and a charger (200), wherein at least one of the electronic device (100) and the charger (200) comprises the charging coil module (1) according to any one of claims 1 to 15, and the charger (200) is configured to charge the electronic device (100).

19. A preparation method for a charging coil module (1), comprising:
preparing a double-sided board (30), wherein the double-sided board (30) comprises a substrate (31), a first etching layer (32), and a second etching layer (33), and the substrate (31) of the double-sided board (30) is located between the first etching layer (32) and the second etching layer (33);
processing the first etching layer (32) of the double-sided board (30) to form a first coil (12) of a charging coil (10) and a first wiring layer (22) of a circuit board (20); and
processing the second etching layer (33) of the double-sided board (30) to form a second coil (13) of the charging coil (10) and a second wiring layer (23) of the circuit board (20).

20. The preparation method for a charging coil module (1) according to claim 19, wherein the first wiring layer (22) comprises a first wire (221), and the first wire (221) and the first coil (12) are of an integrally formed structure; and/or
the second wiring layer (23) comprises a second wire (231), and the second wire (231) and the second coil (13) are of an integrally formed structure.

21. The preparation method for a charging coil module (1) according to claim 19 or 20, wherein the method further comprises:
forming a first covering layer (41) on the first coil (12) of the charging coil (10) and the first wiring layer (22) of the circuit board (20), and forming a second covering layer (42) on the second coil (13) of the charging coil (10) and the second wiring layer (23) of the circuit board (20), wherein the first covering layer (41) comprises a first insulation layer (14) of the charging coil (10) and a first insulation layer (24) of the circuit board (20), and the second covering layer (42) comprises a second insulation layer (15) of the charging coil (10) and a second insulation layer (25) of the circuit board (20).

22. The preparation method for a charging coil module (1) according to claim 19 or 20, wherein along a length direction of the circuit board (20), the circuit board (20) comprises a first part (201), a second part (202), and a third part (203) that are sequentially connected; and when the first part (201) and the third part (203) are folded or unfolded relative to each other, the second part (202) is bent; and
the method further comprises:
forming a first insulation sublayer (241) on a first wiring layer (224) of the second part (202) of the circuit board (20);
forming a second insulation sublayer (242) on a first wiring layer (223) of the first part (201) of the circuit board (20), wherein a part of the second insulation sublayer (242) overlaps the first insulation sublayer (241), and glass transition temperature of the first insulation sublayer (241) is greater than glass transition temperature of the second insulation sublayer (242);
forming a third insulation sublayer (243) on a first wiring layer (225) of the third part (203) of the circuit board (20), wherein a part of the third insulation sublayer (243) overlaps the first insulation sublayer (241), and the glass transition temperature of the first insulation sublayer (241) is greater than glass transition temperature of the third insulation sublayer (243); and
press-fitting the first insulation sublayer (241), the second insulation sublayer (242), and the third insulation sublayer (243).

23. The preparation method for a charging coil module (1) according to claim 22, wherein the press-fitting is a thermal compression bonding process, thermal compression bonding temperature of the thermal compression bonding process ranges from 150°C to 200°C, and thermal compression bonding time of the thermal compression bonding process ranges from 0.5 hour to 3 hours; or
the press-fitting is a pressure transfer process, pressure transfer temperature of the pressure transfer process ranges from 170°C to 190°C, and thermal compression bonding time of the pressure transfer process ranges from 0.5 hour to 3 hours; or
the press-fitting is a rapid pressure bonding process, rapid pressure bonding temperature of the rapid pressure bonding process ranges from 170°C to 190°C, and rapid pressure bonding time of the rapid pressure bonding process ranges from 1 minute to 8 minutes.
